# EUROPEAN PATENT APPLICATION

(11) **EP 4 826 120 A1**
(43) Date of publication of application: **21.10.2026**
(21) Application number: 24903705.2
(22) Date of filing: 11.12.2024
(51) Int. Cl.: C23C 16/511, C23C 16/40, C23C 16/448, H01L 21/205, H01L 21/368

(54) **FILM FORMING APPARATUS AND FILM FORMING METHOD, AS WELL AS CRYSTALLINE METAL OXIDE FILM, AND MULTILAYER STRUCTURE AND SEMICONDUCTOR DEVICE USING SAME**

(30) Priority: 15.12.2023 JP 2023212136
(71) Applicant: SHIN-ETSU CHEMICAL CO., LTD., Tokyo 100-0005 (JP)
(72) Inventor: SAKATSUME Takahiro, Annaka-shi, Gunma 379-0195 (JP)
(74) Representative: Schicker, Silvia
(86) International application number: PCT/JP2024/043729
(87) International publication number: WO 2025/127051

(57) **Abstract**

The present invention is a film forming apparatus including: a misting unit that mists a raw material solution to generate a mist; a carrier gas supply unit that supplies a carrier gas for transporting the mist; a film forming unit that subjects the mist to heat treatment and forms a film on a base body; and a transport unit that connects the misting unit with an inside of the film forming unit and transports the mist by the carrier gas, in which the film forming unit includes a nozzle for supplying the mist in a flow-straightened state to the base body, and a microwave heating device that irradiates the mist in the nozzle with microwaves in a multimode manner to heat the mist. Thereby, a film forming apparatus is provided that can form such a film that in-plane uniformity of film thickness is satisfactory and crystallinity is high at a high film forming rate, by supplying a large amount of mist to a large-diameter substrate while inhibiting foreign substances and abnormal growth.

## Description

### TECHNICAL FIELD

The present invention relates to a film forming apparatus and a film forming method, a crystalline metal oxide film, and a layered structure and a semiconductor device using the crystalline metal oxide film.

### BACKGROUND ART

Conventionally, a high-vacuum film forming apparatus which can realize a non-equilibrium state has been developed, such as a pulsed laser deposition (pulsed laser deposition: PLD) method, a molecular beam epitaxy (molecular beam epitaxy: MBE) method, or a sputtering method, and it has become possible to produce an oxide semiconductor which has been impossible to be produced by a melt method or the like.

In addition, a mist chemical vapor deposition method (Mist Chemical Vapor Deposition: Mist CVD which will be hereinafter referred to also as "mist CVD method") has been developed in which a crystal is grown on a substrate with the use of a raw material atomized to a misty state; and it has become possible to produce gallium oxide having a corundum structure (α-Ga₂O₃). The α-Ga₂O₃ is expected to be applied to a next-generation switching element which can realize high withstand voltage, low losses and high heat resistance, as a semiconductor having a large band gap.

Regarding the mist CVD method, Patent Document 1 describes a tubular furnace type of mist CVD apparatus. Patent Document 2 describes a fine channel type of mist CVD apparatus. Patent Document 3 describes a linear source type of mist CVD apparatus. Patent Document 4 describes a mist CVD apparatus of a tubular furnace, which is different from the mist CVD apparatus described in Patent Document 1 in that a carrier gas is introduced into a mist generator. Patent Document 5 describes a mist CVD apparatus in which a substrate is placed above a mist generator, and further, a susceptor is a rotating stage provided on a hot plate.

### CITATION LIST

### PATENT LITERATURE

Patent Document 1: JP H01-257337A
Patent Document 2: JP 2005-307238A
Patent Document 3: JP 2012-046772A
Patent Document 4: JP 5397794B
Patent Document 5: JP 2014-063973A
Patent Document 6: JP 7080115B
Patent Document 7: JP 6875336B
Patent Document 8: JP 7239919B

### SUMMARY OF INVENTION

### TECHNICAL PROBLEM

Unlike other CVD methods, a mist CVD method can form a film at a relatively low temperature, and can produce a metastable phase of crystalline structure such as a corundum structure of α-Ga₂O₃. However, the present inventor has found that, in the mist CVD method, when a large amount of mist is supplied to a base body in order to improve productivity in forming a film on the base body having a large diameter, the temperature of the film-forming surface of the base body is rapidly lowered because a temperature of the mist is low, which causes such problems as a decrease in crystallinity of the film, damage to the base body, and a decrease in the film forming rate.

Regarding the production of α-Ga₂O₃ by the mist CVD method, Patent document 6 reports an example in which a pipe for transporting mist is heated by a heater to extend the life of the mist and improve a film forming rate. In addition, as a similar attempt, Patent Document 7 reports an example in which a carrier gas for transporting mist is heated, thereby the life of mist is extended, and the film forming rate has been improved.

However, in the methods described in Patent Document 6 and Patent Document 7, as the temperature of the gas becomes higher, the saturated water vapor pressure increases, and accordingly, the evaporation of the mist is promoted. As a result, not only the mist to be supplied to the substrate is reduced, but also a raw material in the mist is deposited and adheres to the film as a foreign substance, which causes a problem of abnormal growth.

Furthermore, when a semiconductor device is manufactured with the use of such a film as to contain a large number of foreign substances, the foreign substances become killer defects, and cause such a problem that the withstand voltage is lowered. In particular, when the foreign substance is large or when foreign substances are gathered even though the foreign substances are small, the foreign substance tends to easily become a killer defect. These foreign substances, which are generated during the film formation, cause abnormal growth when having been embedded in or attached to the film during the film formation, and accordingly, it is desirable to suppress the generation of the foreign substances in the film forming step.

In addition, in Patent Document 8, as a method of suppressing evaporation of mist, an example is reported in which a film forming rate has been improved by causing a carrier gas for transporting mist to contain moisture and thereby increasing relative humidity. However, in this method, the temperature of the film-forming surface of the substrate is lowered by the moisture in the carrier gas, and accordingly, the crystallinity is lowered or the substrate is damaged; and this method could not be used as a method for forming a film on a large-diameter substrate at a high film forming rate.

The present invention has been made to solve the above problems, and the object is to provide: a film forming apparatus and a film forming method that can form a film having satisfactory in-plane uniformity of film thickness and high crystallinity at a high film forming rate, by supplying a large amount of mist to a large-diameter substrate while inhibiting foreign substances and abnormal growth; and a crystalline metal oxide film in which the foreign substances are inhibited.

### SOLUTION TO PROBLEM

The present invention has been made to achieve the above object, and provides a film forming apparatus comprising: a misting unit that mists a raw material solution to generate mist; a carrier gas supply unit that supplies a carrier gas for transporting the mist; a film forming unit that subjects the mist to heat treatment and forms a film on a base body; and a transport unit that connects the misting unit with an inside of the film forming unit and transports the mist by the carrier gas, wherein the film forming unit comprises a nozzle for supplying the mist in a flow-straightened state to the base body, and a microwave heating device that irradiates the mist in the nozzle with microwaves in a multimode manner to heat the mist.

According to such a film forming apparatus, it is possible to heat selectively and rapidly only the mist among the mist and the carrier gas supplied to the base body, thereby suppressing the evaporation of the mist without increasing a saturated water vapor pressure of the carrier gas, and thus enhancing the film forming rate while inhibiting foreign substances and abnormal growth. Furthermore, it is possible to supply the mist of a high temperature to the base body, and accordingly, the temperature drop of the base body is suppressed even if the supply amount of the mist is increased; and it becomes possible to form the film at a high film forming rate without damaging the crystallinity even on the base body having a large diameter. Furthermore, it is possible to form a film having excellent in-plane uniformity of the film thickness, by having a nozzle for straightening the flow of the mist provided therein and by heating the mist in the nozzle, and it becomes possible to simultaneously form films on a plurality of base bodies and improve productivity by being capable of heating a large amount of mist.

At this time, it is possible that the microwave heating device comprises: a microwave generation unit; a microwave irradiation unit that irradiates the mist with microwaves generated in the microwave generation unit; and a microwave waveguide unit through which the microwaves propagate from the microwave generation unit to the microwave irradiation unit, wherein the microwave irradiation unit comprises a wall surface for irregularly reflecting the microwaves to irradiate the mist with the microwaves.

Thereby, it becomes possible to stably irradiate the mist with the microwave.

At this time, it is possible that a portion of the nozzle to be irradiated with the microwaves is formed of a microwave-transmissive member.

Thereby, the microwaves directly reach the mist in the inside, and the mist can be directly heated by the microwaves.

At this time, it is possible that a portion of the nozzle to be irradiated with the microwaves is formed of any one of quartz, ceramic, alumina, a polytetrafluoroethylene resin, a copolymer resin of tetrafluoroethylene and perfluoroalkyl vinyl ether, a copolymer resin of tetrafluoroethylene and hexafluoropropylene, and a polyether ether ketone resin.

Thereby, unintended contamination from a portion of the nozzle which is irradiated with the microwaves can be effectively suppressed.

At this time, it is possible that a representative length of a discharge surface of the nozzle is larger than 3 cm, the mist being discharged from the discharge surface.

Thereby, it becomes possible to further enhance the in-plane uniformity of the film to be produced.

At this time, it is possible that the film forming unit comprises a moving mechanism for moving the base body.

Thereby, it becomes possible to further enhance the in-plane uniformity of the film to be produced.

The present invention also provides a film forming method comprising the steps of: generating mist by atomizing or dropletizing a raw material solution; transporting the mist to a film forming unit by a carrier gas; and forming a film on a base body by supplying the mist to the base body through a nozzle in the film forming unit, and subjecting the mist to heat treatment on the base body, wherein in the step of forming the film on the base body, the mist in the nozzle is irradiated with microwaves in a multimode manner to heat the mist.

According to such a film forming method, it is possible to heat selectively and rapidly only the mist among the mist and the carrier gas supplied to the base body, thereby suppressing the evaporation of the mist without increasing the saturated water vapor pressure of the carrier gas, and thus enhancing the film forming rate while inhibiting foreign substances and abnormal growth. Furthermore, it is possible to supply the mist of high temperature to the base body, and accordingly, the temperature drop of the base body is suppressed even if the supply amount of the mist is increased; and it becomes possible to form the film at a high film forming rate without damaging the crystallinity even on the base body having a large diameter. Furthermore, it is possible to form a film having excellent in-plane uniformity of the film thickness, by having a nozzle for straightening the flow of the mist provided therein and heating the mist in the nozzle, and it is possible to simultaneously form films on a plurality of base bodies and improve productivity by being capable of heating a large amount of mist.

At this time, it is possible that, as the raw material solution, a solution containing a metal raw material and at least one solvent selected from water, methanol, ethanol, ethylene glycol, diethylene glycol, propylene glycol, tetraethylene glycol, glycerol, benzyl alcohol, and dipropylene glycol is used.

Thereby, it is possible to selectively and rapidly heat the mist by microwave heating.

At this time, it is possible that, as the solvent of the raw material solution, a solvent containing water as a main component is used.

Thereby, it becomes difficult for impurities derived from the solvent to remain in the film, and atomization efficiency becomes excellent; and it becomes advantageous also in terms of cost.

At this time, it is possible that, as the metal raw material, a material containing Ga is used.

Thereby, an α-Ga₂O₃ film can be stably produced.

At this time, it is possible that, as the base body, a base body having a film-forming surface with a diameter of 10 cm (4 inches) or larger is used.

When the base body is set to have a large diameter in this way, the crystalline metal oxide film formed on the base body can be formed to have further higher quality and higher productivity.

At this time, it is possible that, in the step of forming the film on the base body, the film is formed on the base body while the base body is being moved.

Thereby, it is possible to produce a film having more improved uniformity.

At this time, it is possible that a frequency of the microwaves is set to 0.9 GHz or higher and 300 GHz or lower.

Thereby, it is possible to stably heat the mist, and to uniformly heat even the inside of the mist keeping a penetration depth of the microwaves to an appropriate length.

At this time, it is possible that the frequency of the microwaves is set to 2.45 GHz or higher and 25 GHz or lower.

Thereby, it is possible to more stably heat the mist, and to more uniformly heat even the inside of the mist keeping a penetration depth of the microwaves to an appropriate length.

The present invention has also been made to achieve the above object, and provides a crystalline metal oxide film comprising at least one of gallium or aluminum as a main component, wherein when a plurality of microscopic images of a plurality of portions of a surface of the crystalline metal oxide film are acquired, each of the microscopic images having an identical field-of-view area of 1 mm² or smaller, such that a total of the field-of-view areas is 20% or larger of an area of the surface of the crystalline metal oxide film and the fields of view of the microscopic images do not overlap, and when the number of foreign substances contained in each of the microscopic images is determined for all of the acquired microscopic images, a ratio of the number of microscopic images determined to contain a plurality of the foreign substances, to the total number of the acquired microscopic images is less than 10%.

It becomes possible to suitably use such a crystalline metal oxide film for a semiconductor device because the film contains few foreign substances and accordingly has satisfactory smoothness, and further because a deviation of the positions of occurrences of foreign substances in the plane is small.

At this time, it is possible that the number density of the foreign substances observed in a surface direction of the crystalline metal oxide film is less than 48/cm².

It becomes possible to suitably use such a crystalline metal oxide film for a semiconductor device because the film contains few foreign substances and accordingly has more satisfactory smoothness.

At this time, it is possible that a distribution of a film thickness measured at 17 or more positions of the crystalline metal oxide film is 4.6% or smaller.

It becomes possible to further suitably use such a crystalline metal oxide film for a semiconductor device because the film has more satisfactory smoothness and the film thickness is more uniform on the entire surface.

At this time, it is possible that the crystalline metal oxide film has a corundum structure.

Such a crystalline metal oxide film becomes a crystalline metal oxide film that has a corundum structure with more satisfactory smoothness.

At this time, it is possible that a half width of a rocking curve of a (006) plane by X-ray diffraction of the crystalline metal oxide film is smaller than 19.1 s.

It becomes possible to suitably use such a crystalline metal oxide film for a semiconductor device because the film has more satisfactory crystallinity.

At this time, it is possible that a diameter of the surface of the crystalline metal oxide film is 10 cm (4 inches) or larger.

It becomes possible to further suitably use such a crystalline metal oxide film for a semiconductor device because the film has more satisfactory smoothness and has a large area.

At this time, it is possible to provide a layered structure comprising: a base body, a buffer layer on the base body, and the above crystalline metal oxide film on the buffer layer.

It becomes possible to suitably use such a layered structure for a semiconductor device because the crystalline metal oxide film has satisfactory smoothness.

At this time, it is possible to provide a semiconductor device comprising the above crystalline metal oxide film and/or the above layered structure.

Such a semiconductor device becomes a semiconductor device having satisfactory electrical characteristics because the crystalline metal oxide film is excellent in smoothness.

At this time, it is possible that the semiconductor device is any one of a semiconductor laser, a diode, or a transistor.

Such a semiconductor device becomes a semiconductor laser, a diode, or a transistor that is excellent in electrical characteristics.

### ADVANTAGEOUS EFFECTS OF INVENTION

As described above, according to the film forming apparatus of the present invention, it is possible to heat selectively and rapidly only the mist among the mist and the carrier gas supplied to the base body, thereby suppressing the evaporation of the mist without increasing the saturated water vapor pressure of the carrier gas, and thus enhancing the film forming rate while inhibiting foreign substances and abnormal growth. Furthermore, it is possible to supply the mist of high temperature to the base body, and accordingly, the temperature drop of the base body is suppressed even when the supply amount of the mist is increased; and it becomes possible to form the film at a high film forming rate without damaging the crystallinity even on the base body having a large diameter. Furthermore, it is possible to form a film having excellent in-plane uniformity of the film thickness, by having a nozzle for straightening the flow of the mist provided therein and heating the mist in the nozzle, and it becomes possible to simultaneously form films on a plurality of base bodies and improve productivity by being capable of heating a large amount of mist.

In addition, according to the film forming method of the present invention, it is possible to heat selectively and rapidly only the mist among the mist and the carrier gas supplied to the base body, thereby suppressing the evaporation of the mist without increasing the saturated water vapor pressure of the carrier gas, and thus enhancing the film forming rate while inhibiting foreign substances and abnormal growth. Furthermore, it is possible to supply the mist of high temperature to the base body, and accordingly, the temperature drop of the base body is suppressed even when the supply amount of the mist is increased; and it becomes possible to form the film at a high film forming rate without damaging the crystallinity even on the base body having a large diameter. Furthermore, it becomes possible to form a film having excellent in-plane uniformity of the film thickness, by having a nozzle for straightening the flow of the mist provided therein and heating the mist in the nozzle, and it becomes possible to simultaneously form films on a plurality of base bodies and improve productivity as a result of being capable of heating a large amount of mist.

In addition, according to the crystalline metal oxide film of the present invention, it is possible to suitably use the crystalline metal oxide film for a semiconductor device, because the film contains few foreign substances and accordingly has satisfactory smoothness, and a deviation of the positions of occurrences of foreign substances in the plane is small, and accordingly an influence of the foreign substances on device characteristics becomes minor when a semiconductor device is manufactured with use of the crystalline metal oxide film. The present invention further provides a layered structure and a semiconductor device that have the crystalline metal oxide film having such features.

### BRIEF DESCRIPTION OF DRAWINGS

[FIG. 1] is a view showing an example of a film forming apparatus according to the present invention;
[FIG. 2] is a view showing an example of a misting unit according to the present invention;
[FIG. 3] is a view showing an example of a nozzle according to the present invention;
[FIG. 4] is a view showing another example of the nozzle according to the present invention;
[FIG. 5] is a view of an example of a reciprocal moving mechanism according to the present invention, as viewed from vertically above the film forming unit;
[FIG. 6] is a view of an example of a rotary moving mechanism according to the present invention, as viewed from vertically above the film forming unit;
[FIG. 7] is a view showing an example of a microwave heating device according to the present invention;
[FIG. 8] is a cross-sectional view of FIG. 7;
[FIG. 9] is a view showing an example of a foreign substance observed in a film produced in Comparative Example;
[FIG. 10] is a view showing an example of an abnormal growth portion observed in a film produced in Comparative Example;
[FIG. 11] is an electron beam diffraction image of the outside of the abnormal growth portion in FIG. 10;
[FIG. 12] is an electron beam diffraction image of a crystal portion observed at the center of the abnormal growth portion in FIG. 10;
[FIG. 13] is a view showing an example of a base body moving mechanism used in Example 6;
[FIG. 14] is a view showing a foreign substance map of Example 5;
[FIG. 15] is a diagram showing a result of counting the number of foreign substances implemented in Example 5;
[FIG. 16] is a diagram showing results of Evaluation 4;
[FIG. 17] is a schematic cross-sectional view showing an embodiment of the structure of a layered structure according to the present invention;
[FIG. 18] is a schematic cross-sectional view showing an example of a Schottky barrier diode according to the present invention;
[FIG. 19] is a schematic cross-sectional view showing an example of a high electron mobility transistor according to the present invention;
[FIG. 20] is a schematic cross-sectional view showing an example of a semiconductor field-effect transistor according to the present invention;
[FIG. 21] is a schematic cross-sectional view showing an example of an insulated gate type bipolar transistor according to the present invention; and
[FIG. 22] is a schematic cross-sectional view showing an example of a light-emitting element diode according to the present invention.

### DESCRIPTION OF EMBODIMENTS

The present invention will be described in detail below, but the present invention is not limited thereto.

As described above, there has been a demand for a film forming apparatus and a film forming method that can form a film having satisfactory in-plane uniformity of film thickness and high crystallinity at a high film forming rate, by supplying a large amount of mist to a large-diameter substrate while inhibiting foreign substances and abnormal growth, and for a crystalline metal oxide film in which the foreign substances are inhibited.

As a result of intensive studies on the above problems, the present inventor has completed the present invention by finding that, by a film forming apparatus including: a misting unit that mists a raw material solution to generate mist; a carrier gas supply unit that supplies a carrier gas for transporting the mist; a film forming unit that subjects the mist to heat treatment and forms a film on a base body; and a transport unit that connects the misting unit with an inside of the film forming unit and transports the mist by the carrier gas, in which the film forming unit includes a nozzle for supplying the mist in a flow-straightened state to the base body, and a microwave heating device that irradiates the mist in the nozzle with microwaves in a multimode manner to heat the mist, it is possible to heat selectively and rapidly only the mist among the mist and the carrier gas supplied to the base body, thereby suppressing the evaporation of the mist without increasing the saturated water vapor pressure of the carrier gas, and thus enhancing the film forming rate while inhibiting foreign substances and abnormal growth; furthermore, it is possible to supply the mist of high temperature to the base body, and accordingly, the temperature drop of the base body is suppressed even when the supply amount of the mist is increased, and it becomes possible to form the film at a high film forming rate without damaging the crystallinity even on the base body having a large diameter; and furthermore, it is possible to form a film having excellent in-plane uniformity of the film thickness, by having a nozzle for straightening the flow of the mist and heating the mist in the nozzle, and it becomes possible to simultaneously form films on a plurality of base bodies and improve productivity as a result of being capable of heating a large amount of mist.

The present inventor has completed the present invention also by finding that, by a film forming method including the steps of: generating mist by atomizing or dropletizing a raw material solution; transporting the mist to a film forming unit by a carrier gas; and forming a film on a base body by supplying the mist to the base body through a nozzle in the film forming unit, and subjecting the mist to heat treatment on the base body, in which in the step of forming the film on the base body, the mist in the nozzle is irradiated with microwaves in a multimode manner to heat the mist, it is possible to heat selectively and rapidly only the mist among the mist and the carrier gas supplied to the base body, thereby suppressing the evaporation of the mist without increasing the saturated water vapor pressure of the carrier gas, and thus enhancing the film forming rate while inhibiting foreign substances and abnormal growth; furthermore, it is possible to supply the mist of high temperature to the base body, and accordingly, the temperature drop of the base body is suppressed even if the supply amount of the mist is increased, and it becomes possible to form the film at a high film forming rate without damaging the crystallinity even on the base body having a large diameter; and furthermore, it is possible to form a film having excellent in-plane uniformity of the film thickness, by having a nozzle for straightening the flow of the mist and heating the mist in the nozzle, and it becomes possible to simultaneously form films on a plurality of base bodies and improve productivity by being capable of heating a large amount of mist.

The present inventor has completed the present invention by further finding that, by a crystalline metal oxide film including at least one of gallium or aluminum as a main component, in which when a plurality of microscopic images of a plurality of portions of a surface of the crystalline metal oxide film are acquired, each of the microscopic images having an identical field-of-view area of 1 mm² or smaller, such that a total of the field-of-view areas is 20% or larger of an area of the surface of the crystalline metal oxide film and the fields of view of the microscopic images do not overlap, and when the number of foreign substances contained in each of the microscopic images is determined for all of the acquired microscopic images, a ratio of the number of microscopic images determined to contain a plurality of the foreign substances, to the total number of the acquired microscopic images is less than 10%, it is possible to suitably use the crystalline metal oxide film for a semiconductor device because the film contains few foreign substances and accordingly has satisfactory smoothness, and further because a deviation of the positions of occurrences of foreign substances in the plane is small.

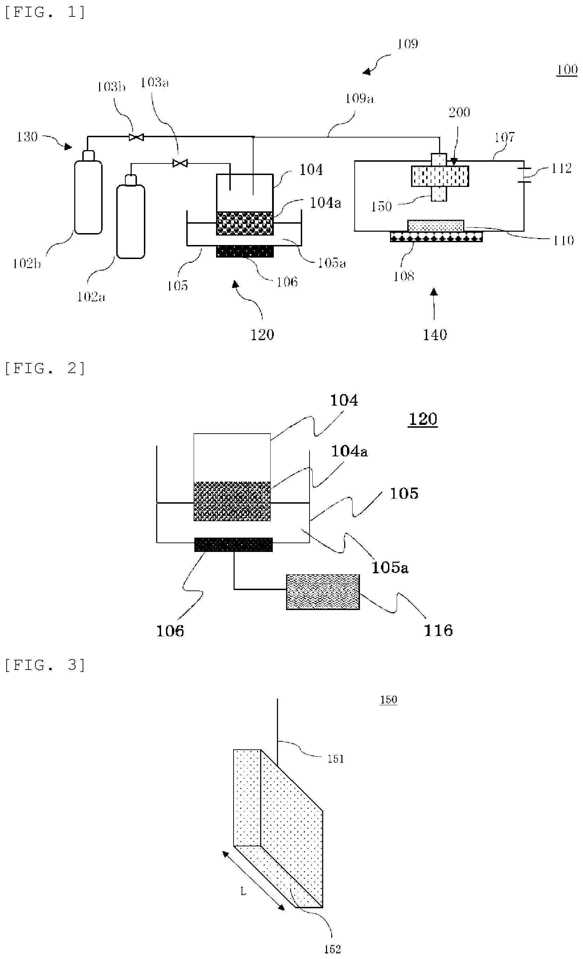

A film forming apparatus according to the present invention will be described below with reference to FIGS. 1 to 8.

### (Film forming apparatus)

FIG. 1 shows an example of a film forming apparatus according to the present invention. A film forming apparatus 100 includes: a misting unit 120 that mists a raw material solution to generate mist; a carrier gas supply unit 130 that supplies a carrier gas for transporting the mist; a film forming unit 140 that subjects the mist to heat treatment and forms a film on a base body; and a transport unit 109 that connects the misting unit 120 with the film forming unit 140 and transports the mist by the carrier gas, in which the film forming unit 140 includes a nozzle 150 for supplying the mist in a flow-straightened state to a base body 110, and a microwave heating device 200 that irradiates the mist in the nozzle with microwaves in a multimode manner to heat the mist. In addition, an operation of the film forming apparatus 100 may be controlled by a controller (not illustrated) that controls the entire or a part of the film forming apparatus 100.

According to such a film forming apparatus, it is possible to heat selectively and rapidly only the mist among the mist and the carrier gas to be supplied to the base body (crystalline substrate) 110, thereby suppressing the evaporation of the mist without increasing the saturated water vapor pressure of the carrier gas, and thus enhancing the film forming rate while inhibiting foreign substances and abnormal growth. Furthermore, it is possible to supply the mist of high temperature to the base body 110, and accordingly, the temperature drop of the base body 110 is suppressed even when the supply amount of the mist is increased, and it becomes possible to form the film at a high film forming rate without damaging the crystallinity even on the base body 110 having a large diameter. Furthermore, it is possible to form a film having excellent in-plane uniformity of the film thickness, by having the nozzle 150 for straightening the flow of the mist provided therein and heating the mist in the nozzle 150, and it becomes possible to simultaneously form films on a plurality of base bodies 110 and improve productivity as a result of being capable of heating a large amount of mist.

### [Misting unit]

In the misting unit 120, the raw material solution is misted to generate mist. The misting means is not particularly limited as long as it can mist the raw material solution, and may be a known misting means, but it is preferable to use a misting means by ultrasonic vibration. This is because the mist can be more stably formed.

An example of such a misting unit 120 is shown in FIG. 2. For example, the misting unit 120 may include a mist generating source 104 in which a raw material solution 104a is accommodated, a vessel 105 in which media that can transmit ultrasonic vibration, for example, water 105a is accommodated, and an ultrasonic vibrator 106 attached to a bottom surface of the vessel 105. Specifically, the mist generating source 104 formed of a vessel in which the raw material solution 104a is accommodated is stored in the vessel 105 in which the water 105a is accommodated, with the use of a support (not illustrated). The ultrasonic vibrator 106 is provided at the bottom of the vessel 105, and the ultrasonic vibrator 106 and an oscillator 116 are connected to each other. In addition, the misting unit 120 is configured such that when the oscillator 116 is operated, the ultrasonic vibrator 106 vibrates, then ultrasonic waves are propagated into the mist generating source 104 through the water 105a, and the raw material solution 104a is misted.

### [Carrier gas supply unit]

A carrier gas supply unit 130 includes a carrier gas source 102a that supplies the carrier gas, and may include a flow-rate adjusting valve 103a that adjusts the flow rate of the carrier gas to be sent from the carrier gas source 102a. Furthermore, it is also possible to provide a carrier gas source for dilution 102b, which supplies a carrier gas for dilution, and a flow-rate adjusting valve 103b for adjusting a flow rate of the carrier gas for dilution, which is sent out from the carrier gas source for dilution 102b, as necessary.

The type of the carrier gas is not particularly limited, and can be appropriately selected depending on a film to be formed. Examples of the gas include oxygen, ozone, inert gases such as nitrogen and argon, and reducing gases such as hydrogen gas and forming gas. In addition, the carrier gas may be one type or two or more types. For example, a diluted gas which has been obtained by diluting the same gas as the first carrier gas with another gas (for example, by diluting the gas to ten times) or the like may be further used as a second carrier gas, and air can also be used.

In addition, the portion from which the carrier gas is supplied may be not only one but also two or more.

A flow rate of the carrier gas is not particularly limited. For example, in a case of forming a film on a substrate having a diameter of 10 cm (4 inches), it is preferable to set the flow rate to 1 to 80 L/min, and is more preferable to set to 4 to 40 L/min. Note that the flow rate of the carrier gas in the present invention is set to a measured value at 20°C and normal pressure, and when the flow rate has been measured at other temperatures and pressures or when a different type of flow rate (mass flow rate, etc.) has been measured, the flow rate can be converted to a volume flow rate at 20°C and normal pressure, with the use of the equation of state of gas.

### [Transport unit]

The transport unit 109 connects the misting unit 120 with the film forming unit 140. The mist is transported by the carrier gas from the mist generating source 104 of the misting unit 120 to a film forming chamber 107 of the film forming unit 140, via the transport unit 109. The transport unit 109 can be, for example, a supply pipe 109a. As the supply pipe 109a, for example, a quartz pipe, a resin-made tube or the like can be used.

### [Film forming unit]

In the film forming unit 140, the mist is heated to cause a thermal reaction, and a film is formed on a part or the whole of the surface of the base body (crystalline substrate) 110. The film forming unit 140 includes, for example, a film forming chamber 107; and in the film forming chamber 107, the base body (crystalline substrate) 110 is installed, and a hot plate 108 for heating the base body (crystalline substrate) 110 can be provided.

The hot plate 108 may be provided outside the film forming chamber 107 as illustrated in FIG. 1, or may be provided inside the film forming chamber 107. In addition, in the film forming chamber 107, an exhaust port 112 for exhaust gas may be provided at a position that does not affect the supply of mist to the base body (crystalline substrate) 110.

Furthermore, the film forming unit 140 includes the nozzle 150 for straightening the flow of the mist and supplying the mist to the base body 110, and the microwave heating device 200 for heating the mist with microwaves.

### [Nozzle]

As shown in FIG. 1, the film forming unit 140 is provided with the nozzle 150 for supplying mist to the base body 110. The nozzle 150 straightens the flow of the mist which flows into the nozzle 150 from the supply pipe 109a, and supplies the mist onto the base body 110. An example of such a nozzle is shown in FIG. 3.

As shown in FIG. 3, the nozzle 150 is preferably a box-shaped member that has a connecting portion 151 which is connected with the transport unit 109, an internal space (not illustrated) for straightening the flow of the mist, and a nozzle discharge surface 152 which discharges the mist toward the base body 110. Here, straightening the flow means to align the directions of the flows of the mist and the carrier gas which are discharged from the nozzle discharge surface.

The installation position of the nozzle is not particularly limited. As shown in FIG. 1, the base body 110 may be installed on a lower surface of the film forming chamber 107, and the nozzle 150 may be disposed vertically above the base body 110, in other words, may be laid face up or the base body 110 may be installed on an upper surface of the film forming chamber 107, and the nozzle 150 may be disposed vertically below the base body, in other words, may be laid face down.

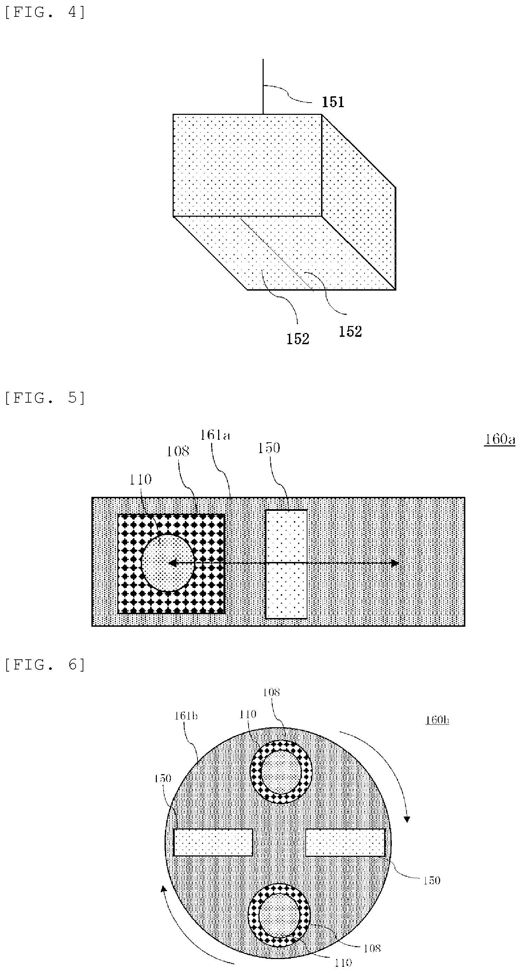

The number of nozzles and the number of nozzle discharge surfaces are not particularly limited as long as the number is one or more. A plurality of nozzles may be provided, and a plurality of nozzle discharge surfaces 152 may be provided, as in the nozzle illustrated in FIG. 4.

In addition, an angle formed by a plane including the nozzle discharge surface 152 and a plane including the surface of the base body 110 is not particularly limited. A nozzle (not illustrated) in which a part or all of the nozzle discharge surface 152 is inclined may be provided so that the mist easily flows in a specific direction, but it is preferable that the nozzle is arranged so that the base body 110 and the nozzle discharge surface 152 are parallel to each other as in FIG. 1. This is because a film having satisfactory in-plane uniformity of the film thickness can be formed with a simpler structure.

In addition, the nozzle 150 may be provided with such a nozzle position adjusting mechanism (not illustrated) as to be capable of appropriately adjusting the longest distance among the distances between an arbitrary point in the nozzle discharge surface 152 and the surface of the base body 110. The longest distance among the distances between an arbitrary point in the nozzle discharge surface 152 and the surface of the base body 110 is not particularly limited, but is preferably 0.1 cm or larger and smaller than 10 cm, is more preferably 0.1 cm or larger and smaller than 6 cm, and is further preferably 0.1 cm or larger and smaller than 3 cm. When the distance is 0.1 cm or larger, the contact between the nozzle 150 and the base body 110 due to heat expansion during film formation can be effectively prevented, and when the distance is smaller than 10 cm, the in-plane uniformity of the film thickness can be further improved.

The shape of the nozzle discharge surface 152 is not particularly limited, and may be polygonal, circular, elliptical, or the like, but is preferably quadrangular, and is more preferably rectangular.

In addition, it is preferable that the representative length L [cm] of the nozzle discharge surface 152 of the nozzle 150 is larger than 3 cm, the mist being discharged from the discharge surface. The L can be determined as appropriate according to the size of the base body 110, but is preferably longer than the representative length R [cm] of the base body 110. Note that the representative length in the present invention refers to a diameter in the case of a circle, a major axis length in the case of an ellipse, and a length of the longest side in the case of a polygon. For example, when the base body 110 is a circular shape having a diameter of 4 inches, the R is about 10 cm, and when the nozzle discharge surface is a rectangle having a long side of 15 cm and a short side of 2 cm, the L is 15 cm.

When the L is larger than 3 cm or larger than the R, the in-plane uniformity of the film to be produced can be further improved. The upper limit of the L is not particularly limited, but can be, for example, about twice the representative length R of the base body 110. When the L is twice or smaller, an effective amount of the mist is supplied to the base body, and the utilization efficiency of the raw material can be effectively maintained.

In addition, the film forming unit 140 can include a moving mechanism that moves the base body 110 at a lower side of the nozzle 150. FIG. 5 and FIG. 6 show views of a reciprocal moving mechanism 160a and a rotary moving mechanism 160b provided in the film forming unit 140, as viewed from vertically above the base body 110. As shown in FIGS. 5 and 6, the moving mechanisms include moving stages 161a and 161b, respectively, on which the base body 110 and the hot plate 108 are placed.

According to such a moving mechanism, the in-plane uniformity of the film to be produced can be further improved.

It is preferable that a portion of the nozzle 150 to be irradiated with the microwaves is formed of a microwave-transmissive member.

Due to the material that easily transmits microwaves composing the portion, the microwaves directly reach the mist in the inside, and the mist can be directly heated by the microwaves.

The microwave heating can generate heat in a very short time as compared with the conventional heating by heat transfer, and accordingly, the mist can be quickly heated to a predetermined temperature.

The material for forming the portion of the nozzle 150 to be irradiated with the microwaves is not particularly limited as long as the material has microwave permeability, and can be appropriately selected according to the purpose; examples thereof include quartz, ceramic, alumina, a polytetrafluoroethylene resin, a tetrafluoroethyleneperfluoroalkyl vinyl ether copolymer resin, a tetrafluoroethylene-hexafluoropropylene copolymer resin, a polyether ether ketone resin, glass, sapphire, a polyethylene resin, and the like; and among the materials, any of quartz, ceramic, alumina, a polytetrafluoroethylene resin, a tetrafluoroethyleneperfluoroalkyl vinyl ether copolymer resin, a tetrafluoroethylene-hexafluoropropylene copolymer resin and a polyether ether ketone resin is more preferable.

With such a material, unintended contamination from the portion of the nozzle 150 can be effectively suppressed which is irradiated with the microwaves.

In order to avoid contact between the nozzle 150 and the raw material solution, the inner wall surface of the nozzle 150 may be subjected to surface treatment according to the type of the solvent contained in the raw material solution. For example, when the solvent is water, the surface of the inner wall surface may be subjected to hydrophobic treatment by irradiation with ultraviolet rays, ultrasonic waves and radiation, or may be subjected to hydrophobic treatment which uses a hydrophobic material such as a silane coupling agent or a polytetrafluoroethylene resin. In addition, in any case, the material of the portion of the nozzle 150, which is not irradiated with the microwaves, is not particularly limited.

The thickness of the wall of the nozzle 150 is not particularly limited, and may be appropriately selected according to the intended purpose, but is preferably from 0.05 mm to 10 mm, and is more preferably from 0.1 mm to 2 mm. When the thickness is in the range of 0.05 mm to 10 mm, it becomes possible to maintain an appropriate strength, to effectively prevent a damage due to pressure fluctuation in the nozzle 150, and to effectively prevent a decrease in heating efficiency due to transmission loss of the microwaves.

In addition, a volume V [cm³] of the internal space of the nozzle 150 is not particularly limited. The volume V can be appropriately determined according to the flow rates of the carrier gas and the mist, but when the flow rate of the carrier gas is determined to be Q [cm³/s], it is preferable to be set as 0.01≤V/Q≤10. When the V/Q is in this range, it is possible to appropriately straighten the flow of the mist and heat the mist, and accordingly, it is possible to keep the uniformity of the film thickness and the film forming rate at an appropriate level, and it is possible to suppress the evaporation of the mist, and accordingly, it is possible to effectively prevent the lowering of the film quality.

### [Microwave heating device]

The microwave heating device is not particularly limited as long as the device can emit microwaves, and includes a known microwave generation unit, a microwave irradiation unit formed of an electroconductive material such as aluminum, copper or brass, and a microwave waveguide unit; and at least a part of the nozzle 150 is arranged in the microwave irradiation unit so as to pass through a microwave irradiation space of the microwave irradiation unit.

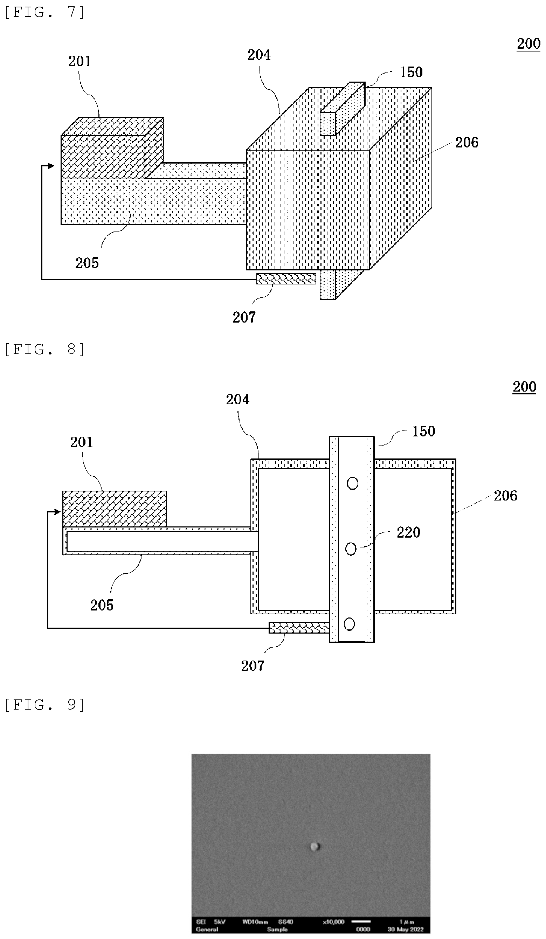

An example of the microwave heating device according to the present invention is shown in FIGS. 7 and 8. FIG. 8 is a cross-sectional view of FIG. 7. As shown in FIG. 7, a microwave heating device 200 according to the present invention includes a microwave generation unit 201, a microwave irradiation unit 204 that irradiates mist with the microwaves which have been generated by the microwave generation unit, and a microwave waveguide unit 205 that propagates the microwaves from the microwave generation unit to the microwave irradiation unit; and the microwave irradiation unit includes a wall surface 206 for irregularly reflecting the microwaves and irradiating the mist with the microwaves.

Such a microwave heating device can stably irradiate the mist with the microwaves.

The microwave heating device 200 is arranged in the film forming unit 140. If the distance from the microwave heating device 200 to the base body 110 is too large, the mist heated by the microwaves dissipates heat, and the temperature of the mist decreases, and furthermore, the temperature of the surrounding carrier gas increases, thereby, the saturated vapor pressure increases, the evaporation of the mist is promoted, and the film forming rate decreases.

Microwave heating includes a multimode manner as is typified by a microwave oven, and a single mode manner in which one standing wave is formed in a waveguide; the microwave heating device 200 of the present invention uses the multimode manner. The single mode manner is excellent in heating efficiency, but a space that can be heated is limited, and accordingly, it is difficult to use a member for straightening the flow of mist, such as a nozzle, and the in-plane uniformity of film thickness becomes deteriorated, or it is difficult to form a film on a plurality of base bodies, and accordingly, productivity becomes poor.

The standing wave is a wave motion in which the waveform does not advance but appears to stop and vibrate, and a state is created in which the positions of a place where the electric field intensity is 0 and a place where the electric field intensity is strong do not change with time.

In the microwave heating in the multimode manner, the mist, which is an object to be heated, is irradiated with the microwaves generated by the microwave generation unit while the microwaves are irregularly reflected by the wall surface of the microwave irradiation unit. Because of this, it is not necessary to control the size of the microwave irradiation unit or the microwave waveguide unit, and form a standing wave; and the device is simplified, and furthermore, it is possible to emit the microwaves even to a space having a large volume.

The microwave heating device 200 with the multimode manner according to the present invention includes a microwave oscillator as the microwave generation unit 201, an applicator as the microwave irradiation unit 204, and a waveguide as the microwave waveguide unit 205, and the applicator 204 has a wall surface 206 that irregularly reflects the microwaves, and a part or all of the nozzle 150 is arranged in the applicator 204 so as to pass through the microwave irradiation space.

The microwaves are output from the microwave oscillator 201, propagate through the waveguide 205, enter the applicator 204, and are irregularly reflected in the applicator 204. A part of the energy of the microwaves is absorbed by the mist passing through the nozzle 150.

In addition, the microwave heating device 200 may include a thermometer 207 which measures the temperature of the nozzle 150.

The microwave oscillator 201 may be a magnetron type, or may be a semiconductor type (or a solid-state type), and in the present invention, the magnetron type is preferable. This is because the magnetron type enables microwave irradiation with a large output.

The material of the applicator 204 is not particularly limited, and may be formed from an electroconductive material such as aluminum, copper or brass. In addition, the outer surface of the applicator 204 may be subjected to an acid-resistant coating. This is because the material is less likely to be corroded even in an acidic raw material solution. The acid-resistant coating agent is not particularly limited, and a known coating agent such as Teflon (registered trademark) can be used.

The shape of the applicator 204 is not particularly limited. Specifically, a box-shaped vessel such as a microwave oven can be used. The microwaves emitted into the applicator 204 are irregularly reflected by the wall surface of the applicator 204, and thereby, the microwaves can be emitted to a space having a large volume.

In addition, a relative position between the nozzle 150 and the applicator 204 is not particularly limited, but as in FIG. 8, it is preferable that the nozzle 150 is included in the center of the internal space of the applicator 204. This is because the irradiation efficiency of the microwaves is excellent.

The material of the waveguide 205 is not particularly limited, and the waveguide may be formed of an electroconductive material such as aluminum, copper or brass. In addition, the outer surface of the waveguide 205 may be coated with an acid-resistant coating. This is because the material is less likely to be corroded even in an acidic raw material solution. The acid-resistant coating agent is not particularly limited, and a known coating agent such as Teflon (registered trademark) can be used.

The cross-sectional shape of the waveguide 205 is not particularly limited, and may be circular, elliptical, rectangular, or the like.

### (Crystalline metal oxide film)

Next, the crystalline metal oxide film of the present invention will be described. The crystalline metal oxide film of the present invention is a crystalline metal oxide film including at least one of gallium or aluminum as a main component, in which when a plurality of microscopic images of a plurality of portions of a surface of the crystalline metal oxide film are acquired, each of the microscopic images having an identical field-of-view area of 1 mm² or smaller, such that a total of the field-of-view areas is 20% or larger of an area of the surface of the crystalline metal oxide film and the fields of view of the microscopic images do not overlap, and when the number of foreign substances contained in each of the microscopic images is determined for all of the acquired microscopic images, a ratio of the number of microscopic images determined to contain a plurality of the foreign substances, to the total number of the acquired microscopic images is less than 10%.

It is possible to suitably use such a crystalline metal oxide film for a semiconductor device because the film contains few foreign substances and accordingly has satisfactory smoothness, and further because a deviation of the positions of occurrences of foreign substances in the film surface is small.

Note that the surface of the crystalline metal oxide film in the present invention refers to one of the front and back surfaces of the crystalline metal oxide film.

The surface direction in the present invention refers to, when a direction from the back surface side to the front surface side of the crystalline metal oxide film is defined as a z-axis positive direction, a direction from a side where the z coordinate is larger than the surface of the crystalline metal oxide film to a side where the z coordinate is smaller.

In the present invention, the position of the foreign substance is not particularly limited as long as the foreign substance can be observed from the surface direction. The foreign substance may be attached to the surface, or may be partially or fully embedded in the film. The observation method will be described later, but is not particularly limited. The height in the observation direction can be distinguished with the use of a confocal microscope or the like.

In general, a crystalline metal oxide film is composed of a metal and oxygen, but in the crystalline metal oxide film according to the present invention, the metal contains at least one of gallium or aluminum as a main component. The main component as used herein means that 50 to 100 atom% of the metal component is gallium or aluminum. In addition, the main component also means that the total of gallium and aluminum is 50 to 100 atom%.

As a metal component other than gallium or aluminum, for example, one or more metals selected from iron, indium, vanadium, titanium, chromium, rhodium, iridium, nickel and cobalt may be contained.

The microscopic image according to the present invention refers to a microscopic image obtained by observation of the crystalline metal oxide film from the surface direction.

In the present invention, the method of acquiring the microscopic image is not particularly limited. An image may be taken while a crystalline metal oxide film is placed on an observation stage and the position is manually changed, but such a method is preferable as to control the stage by electric driving and automatically take the microscopic image at a predetermined position. This is because the imaging can be performed efficiently and stably.

In the present invention, the total of the field-of-view areas of the acquired microscopic images may be 20% or more of the area of the surface of the crystalline metal oxide film. The larger the total of the field-of-view areas is, the more satisfactory it is, and it is more preferable to inspect 90% or more (substantially entire surface) of the surface. The upper limit can be, for example, 100%. In addition, when the total of the field-of-view areas is less than 20% of the area of the surface of the crystalline metal oxide film, in a case in which the foreign substance is locally generated, there is a high possibility that the foreign substance is not included in the observation range, and thus, the inspection does not become significant.

As a measurement method for observing such an area, for example, there is a method of controlling an electric XY stage to set the field-of-view size of a microscopic image to 1×1 mm, and automatically photographing the entire surface of the wafer surface at 2 mm intervals by an imaging camera. With such a method, 1789 points (=17.89 cm²) of microscopic images can be automatically taken in a wafer having a diameter of 4 inches, becoming 20% or more of the entire surface of the wafer surface of 4 inches.

The field-of-view area per one microscopic image is preferably 1 mm² or less and 0.5 mm² or more. The lower limit of the field-of-view area is not particularly limited, but can be set to 0.1 mm². When the field-of-view area is set larger than 1 mm² (in other words, when magnification is set low), it becomes difficult to identify a small foreign substance, and when the field-of-view area is set too small (in other words, when magnification is set high), the number of images to be captured increases, and thus the evaluation becomes complicated.

In the present invention, a ratio of the number of microscopic images determined to contain a plurality of foreign substances to the total number of acquired microscopic images may be less than 10%, but is more preferably 5% or less, and is further preferably 1% or less. The lower limit is not particularly limited, but the smaller the ratio is, the more satisfactory it is, and the lower limit is, for example, 0%. If there are so many foreign substances as a plurality of foreign substances exist in the field-of-view area, killer defects tend to easily occur when a semiconductor device is manufactured, and the semiconductor device tends to easily have a low withstand voltage. When the ratio of the number of microscopic images including a plurality of foreign substances to the total number of acquired microscopic images is smaller than 10%, the yield of the manufactured semiconductor device becomes satisfactory, and the crystalline metal oxide film becomes industrially excellent.

In addition, the foreign substance according to the present invention is a particle as shown in FIG. 9, which is derived from the metal raw material in the mist. The mechanism by which the foreign substance is formed is not clear, but it is considered that the metal raw material has been deposited due to the evaporation of the moisture in the mist during film formation, and that a metal oxide has been formed due to a side reaction of the metal raw material in the gas phase. The majority of these particles are amorphous. The method of analyzing the compositions of the particles is not particularly limited. The composition can be examined by EDX, Auger electron spectroscopy, SIMS, or the like. In addition, the analysis method of the crystal structure is not also particularly limited. The crystal structure can be examined by a general method such as electron beam diffraction.

When these particles are attached to or embedded in the film surface, a part or all of the particles are crystallized by heat. However, at this time, not the α phase but the γ phase of an aluminum oxide crystal or a gallium oxide crystal, or mixed crystals thereof grow. Because of this, when a voltage is applied to a film in which the foreign substance is found, an electric field concentrates on a grain boundary portion between the α phase and the γ phase, and dielectric breakdown easily occurs. In the case of a crystalline metal oxide film in which the ratio of the number of microscopic images including a plurality of foreign substances to the total number of acquired microscopic images is smaller than 10%, dielectric breakdown due to the formation of the grain boundary can be sufficiently suppressed, and accordingly, a semiconductor device can be manufactured with high yield with the use of the crystalline metal oxide film.

The shape and quantity of the foreign substance can be determined by observing the shape and evaluating the number of occurrences with an electron microscopy such as TEM, an optical microscopy, a surface-inspection device that detects defects from a difference in brightness, a surface-inspection device that uses an image-recognition AI and makes a machine learn and detect defects, or the like, in addition to the SEM that observes the foreign substance in FIG. 9, but the observation method and the method of evaluating the number of occurrences are not particularly limited.

A particle size of the foreign substance in the present invention is 10 nm to 10 µm. Note that the particle size which is used herein refers to a circle-equivalent diameter in a two-dimensional image observed from the surface direction of the crystalline metal oxide film. The circle-equivalent diameter is a diameter of a circle having an area equivalent to an area of a particle captured in the two-dimensional image, and the particle area can be calculated by image analysis or the like.

The particle size distribution can be created by measuring the particle size of the foreign substance with the previously described method. In the crystalline metal oxide film according to the present invention, a standard deviation of the particle size may be smaller than 1.25 um, is preferably smaller than 0.50 µm, and is more preferably 0.30 µm or smaller.

Such a crystalline metal oxide film can be suitably used for a semiconductor device, because the foreign substance is small in size and uniform, and when the semiconductor device has been manufactured, the influence of the foreign substance on the device characteristics becomes further minor. The lower limit is not particularly limited. The smaller the value is, the more satisfactory it is, and for example, the value can be 0 (which is the case in which all values are the same). Note that the standard deviation σ can be calculated according to the following equation.$σ = \sqrt{\frac{1}{n} {\sum }_{i = 1}^{n} {\left({x}_{i}-{x}^{˜}\right)}^{2}}$ where n is the number of data, xᵢ is each data, and x bar is an average value.

In addition, in the crystalline metal oxide film according to the present invention, the index of the particle size distribution D90/D10 may be smaller than 5.7, is preferably 4.0 or smaller, and is more preferably 3.0 or smaller.

In such a crystalline metal oxide film, the size of the foreign substance is more uniform, the design of the semiconductor device becomes easier, and the crystalline metal oxide film can be suitably used for the semiconductor device. The lower limit is not particularly limited, but is usually about 1.5.

Note that the particle size D90 in the present invention refers to a particle size at which a cumulative ratio in the particle size distribution becomes 90%, the particle size D10 refers to a particle size at which the cumulative ratio becomes 10%, and the particle size D50 refers to a particle size at which the cumulative ratio becomes 50%.

The value of the particle size D90 is not particularly limited, but for example, may be smaller than 4.25 µm, and is more preferably 1.0 µm or smaller. In addition, the lower limit is not particularly limited. The smaller the value is, the more satisfactory it is, and for example, the value can be larger than 1 nm.

Such a crystalline metal oxide film can be suitably used for a semiconductor device, because the foreign substance is small in size, and when the semiconductor device has been manufactured, the influence of the foreign substance on the device characteristics becomes further minor.

The value of the particle size D10 is not particularly limited. The smaller the particle size is, the crystalline metal oxide film can be suitably used for a semiconductor device, because when the semiconductor device has been manufactured, the influence of the foreign substance on the device characteristics becomes minor.

In addition, in the crystalline metal oxide film according to the present invention, the particle size D50 at which the cumulative ratio in the particle size distribution becomes 50% may be smaller than 2.75 µm, is preferably 2.0 µm or smaller, and is more preferably 0.5 µm or smaller. In addition, the lower limit is not particularly limited. The smaller the value is, the more satisfactory it is, and for example, the value can be larger than 1 nm.

Such a crystalline metal oxide film can be suitably used for a semiconductor device, because when the semiconductor device has been manufactured, the influence of the foreign substance on the device characteristics becomes further minor.

In the crystalline metal oxide film according to the present invention, the ratio of particles having a particle size not smaller than (particle size D50 - standard deviation σ) and not larger than (particle size D50 + standard deviation σ) to the total number of foreign substances may be 60% or larger, and is more preferably 75% or larger. The ratio is preferable when it is higher, and the upper limit can be, for example, 100%.

Such a crystalline metal oxide film can be suitably used for a semiconductor device, because the foreign substance is small in size, and when the semiconductor device has been manufactured, the influence of the foreign substance on the device characteristics becomes further minor.

In the crystalline metal oxide film, the number of foreign substances observed from the surface direction of the film may be less than 48/cm², is preferably 10/cm² or less, and is further preferably less than 1/cm². The lower limit of the foreign substance is not particularly limited. The number of the foreign substance is preferable when it is smaller, and the number may be 0.01 pieces/cm² or more.

Such a crystalline metal oxide film can be further suitably used for a semiconductor device, because the smoothness of the film is further satisfactory.

In addition, it is possible to produce the crystalline metal oxide film so as to have a corundum structure.

Such a crystalline metal oxide film becomes a crystalline metal oxide film having a corundum structure, in which the smoothness is more satisfactory.

In addition, in the crystalline metal oxide film according to the present invention, the half width of the rocking curve of X-ray diffraction peak on a (006) plane may be smaller than 19.1 seconds, and is more preferably 9.4 seconds or smaller.

A measurement apparatus and a measurement method of the half width of the X-ray diffraction peak on a (006) plane are not particularly limited. For example, an X-ray diffractometer (SmartLab manufactured by Rigaku Holdings Corporation) is used to perform Out-of-Plane XRD 2θ/ω scan measurement of an oxide semiconductor film formed on a base body, and 2θ and ω are examined at which the peak of the (006) plane is obtained. After that, the half width of the rocking curve can be measured by fixing the diffraction angle at 2θ at which the peak of the (006) plane has been obtained, and by performing ω scan.

The measurement conditions at this time are not particularly limited, and can be, for example, as follows.
· Measurement apparatus: SmartLab (trade name) manufactured by Rigaku Holdings Corporation
· Analysis conditions
   Measurement method: Out-of-Plane XRD method (2θ/ω scan)
   X-ray generating unit: counter cathode Cu
      : output 45 kV 200 mA
      Detection unit: semiconductor detector
   Incident optical system: Ge (220) channel cut monochromator
   Soller slit: incident side -
      : light receiving side 5.0°
   Slit: incident side IS= 1 (mm)
      : longitudinal limit 0.5 (mm)
      : light receiving side RS1= 1 RS2= 1.1 (mm)
   Scanning conditions: scanning axis 2θ/ω
      : scanning mode step measurement
      : scanning range 35 to 45°
      : step width 0.005°
      : accumulation time 0.5 sec./step
· Measurement apparatus: SmartLab (trade name) manufactured by Rigaku Holdings Corporation
· Analysis conditions
   Measurement method: rocking curve measurement (ω scan)
   X-ray generating unit: counter cathode Cu
      : output 45 kV 200 mA
      Detection unit: semiconductor detector
   Incident optical system: Ge (220) channel cut monochromator
   Soller slit: incident side -
      : light receiving side 5.0°
   Slit: incident side IS= 1 (mm)
      : longitudinal limit 0.5 (mm)
      : light receiving side RS1= 1 RS2= 1.1 (mm)
   Scanning conditions: evaluation diffractive surface Ga₂O₃ (006)
      : scanning axis ω
      : scanning mode step measurement
      : scanning range 19 to 22°
      : step width 0.005°
      : accumulation time 0.5 sec./step

It becomes possible for such a crystalline metal oxide film to be suitably used for a semiconductor device, because the crystal orientation is more satisfactory. Note that the half width of the rocking curve is preferable when it is smaller, and accordingly, the lower limit is, for example, more than 0 seconds.

The crystalline metal oxide film can contain a dopant depending on an application. The dopant is not particularly limited. Examples of the dopant include n-type dopants such as tin, germanium, silicon, titanium, zirconium, vanadium and niobium, and p-type dopants such as copper, silver, tin, iridium and rhodium. The concentration of the dopant may be, for example, about 1.0×10¹⁶ to 1.0×10²² /cm³, and may be set to a low concentration of about 1.0×10¹⁷ /cm³ or lower, or to a high concentration of about 1.0×10²⁰ /cm³ or higher.

The film thickness of the crystalline metal oxide film according to the present invention is not particularly limited. For example, it may be 0.05 to 100 µm, is preferably 0.1 to 50 µm, and is more preferably 0.5 to 20 µm.

In addition, as for the crystalline metal oxide film according to the present invention, a distribution of the film thickness measured at least 17 points or more in the plane may be 4.6% or smaller, and is more preferably 2.8% or smaller.

Such a film can be suitably used for a semiconductor device, because the surface is flatter, and furthermore, the film thickness is more uniform. Note that the distribution of the film thickness is preferable when it is smaller, and accordingly, the lower limit is, for example, more than 0%.

The number of measurement points may be 17 points or more; and the number of measurement points and the measurement positions are not particularly limited, but it is preferable to provide the measurement points symmetrically with respect to the center of the substrate. For example, in a polar coordinate system (r, θ) in which the center of the substrate is set as the origin point, when a radius of the base body is set as R, the measurement points can be 17 points represented by:
r= 0, R/4, and R/2; and
θ= 0, π/4, π/2, 3π/4, π, 5π/4, 3π/2, 7π/4, and 2π.

The upper limit of the number of measurement points is not particularly limited, but for example, can be set to 81 points. If the number of measurement points is too many, the inspection process becomes complicated, and the productivity is lowered.

With the use of the maximum film thickness D_{Max}, the minimum film thickness D_{Min}, and the mean film thickness D_{Ave} among the above measurement points, the film thickness distribution χ[%] can be calculated according to the following expression.$χ = \frac{\left({D}_{Max}-{D}_{Min}\right)}{2 {D}_{Ave}} \times 100$

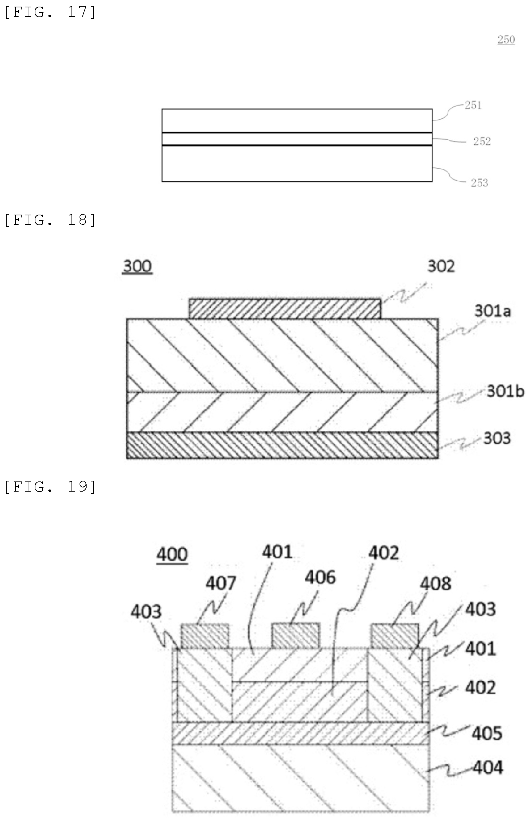

The crystalline metal oxide film may be formed directly on the base body, or may be layered on an intermediate layer 252 (buffer film or release film) formed on a base body 253, as shown in FIG. 17. The intermediate layer is not particularly limited as long as the composition is a metal oxide capable of forming a corundum structure, and can contain an oxide containing, for example, any of aluminum, titanium, vanadium, chromium, iron, gallium, rhodium, indium and iridium, as a main component.

More specifically, the intermediate layer is Al₂O₃, Ti₂O₃, V₂O₃, Cr₂O₃, Fe₂O₃, Ga₂O₃, Rh₂O₃, In₂O₃ and Ir₂O₃; and may be a metal oxide of a binary system represented by (AₓB₁₋ₓ)₂O₃ (0<x<1) when two elements selected from the above metallic elements are determined as A and B, or a metal oxide of a ternary system represented by (AₓB_{y}C_{1-x-y})₂O₃(0<x<1, 0<y<1) when three elements selected from the above metallic elements are determined as A, B and C.

It is preferable that a diameter of the crystalline metal oxide film is 10 cm (4 inches) or larger. The upper limit of the area is not particularly limited, but may be 750 cm² or smaller, and in the case of a circular shape, the area may correspond to the diameter of 12 inches (300 mm) or smaller.

Such a crystalline metal oxide film can be further suitably used for a semiconductor device, due to having more satisfactory smoothness and a large area.

### (Method for producing crystalline metal oxide film)

As for a method for producing the crystalline metal oxide film according to the present invention, the film can be formed by a mist CVD method including a step of heating with microwaves as will be described later.

### (Layered structure)

FIG. 17 is a view showing an embodiment of the structure of a layered structure according to the present invention. The layered structure 250 having the crystalline metal oxide film according to the present invention basically includes the base body 253 and the crystalline metal oxide film 251. At this time, the previously described intermediate layer 252 may be included between the base body 253 and the crystalline metal oxide film 251.

The crystalline metal oxide film and the layered structure according to the present invention can be used for a semiconductor device, due to appropriate designing of the structure. The crystalline metal oxide film and the layered structure can constitute the semiconductor layer of each of, for example, a Schottky barrier diode (SBD), a metal semiconductor field-effect transistor (MESFET), a high electron mobility transistor (HEMT), a metal oxide semiconductor field-effect transistor (MOSFET), a static induction transistor (SIT), a junction field-effect transistor (JFET), an insulated gate bipolar transistor (IGBT), a light emitting diode (LED), and the like.

### (Semiconductor Device)

In addition, the semiconductor device according to the present invention includes at least one of the above described crystalline metal oxide film and/or the above described layered structure. For example, a semiconductor device (semiconductor element) such as a semiconductor laser, a diode or a transistor can be provided. Such a semiconductor device may be the device including the base body or may be the device from which the base body is removed. The semiconductor device according to the present invention is a high-quality semiconductor device in which a high-quality crystalline metal oxide film with satisfactory flatness is used. Application examples (specific examples) of the semiconductor device are as follows.

### (Examples of applicable semiconductor device)

The crystalline metal oxide film and the layered structure including the crystalline metal oxide film as described above have satisfactory flatness and excellent electrical characteristics, and are industrially useful. Such a crystalline metal oxide film and a layered structure having a crystalline metal oxide film can be suitably used for various semiconductor devices and the like, and are particularly useful for a power device.

In addition, semiconductor devices can be classified into a horizontal element (horizontal device) in which an electrode is formed on one surface side of a crystalline metal oxide film, and a vertical element (vertical device) in which an electrode is formed on both front and back surface sides of the crystalline metal oxide film. The semiconductor device of the present invention can be suitably used for both the horizontal device and the vertical device, but is preferably used for the vertical device. Examples of the semiconductor device include a Schottky barrier diode (SBD), a metal semiconductor field-effect transistor (MESFET), a high electron mobility transistor (HEMT), a semiconductor field-effect transistor (MOSFET), a junction field-effect transistor (JFET), an insulated gate bipolar transistor (IGBT), and a light-emitting diode (LED).

### (Method for manufacturing semiconductor device)

First, a crystalline metal oxide film is formed on a main surface of a base body directly or via another layer, and a layered structure according to the present invention is obtained. After that, an electrode and the like are formed on the crystalline metal oxide film, and thereby, a semiconductor device is manufactured. At this time, the layered structure including the base body and the crystalline metal oxide film can be used as it is, or the base body may be removed to leave the intermediate layer and the crystalline oxide semiconductor film, or the base body and the intermediate layer may be removed to leave only the crystalline oxide semiconductor film. In this way, a high-performance semiconductor device which uses a high-quality crystalline metal oxide film with satisfactory flatness can be manufactured.

Preferable examples of the case in which the crystalline metal oxide film of the present invention is applied to an n-type semiconductor layer (n+-type semiconductor, n--type semiconductor layer, or the like) will be described below with reference to the drawings, but the present invention is not limited to these examples. Note that the semiconductor elements exemplified below may further include another layer (for example, an insulator layer or a conductor layer) or the like, and, for example, an intermediate layer or a stress relief layer (a buffer layer) may be omitted as appropriate.

FIG. 18 shows an example of an SBD (Schottky barrier diode) according to the present invention. The SBD 300 includes an n--type semiconductor layer 301a which has been subjected to a relatively low concentration of doping, an n+-type semiconductor layer 301b which has been subjected to a relatively high concentration of doping, a Schottky electrode 302, and an ohmic electrode 303.

The material of the Schottky electrode 302 and the ohmic electrode 303 may be a known electrode material, and examples of the electrode materials include: metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium and silver, or alloys thereof; electroconductive films of metal oxides such as tin oxide, zinc oxide, rhenium oxide, indium oxide, indium tin oxide (ITO) and indium zinc oxide (IZO); organic electroconductive compounds such as polyaniline, polythiophene and polypyrrole; and mixtures or layered products thereof.

The Schottky electrode 302 and the ohmic electrode 303 can be formed by a known method such as a vacuum deposition method or a sputtering method. More specifically, for example, in the case of forming a Schottky electrode with the use of two types of metals among the above metals, which are a first metal and a second metal, the Schottky electrode can be formed by stacking a layer formed from the first metal and a layer formed from the second metal, and subjecting the layer formed from the first metal and the layer formed from the second metal to patterning which uses a photolithographic method.

When a reverse bias has been applied to the SBD 300, a depletion layer (not illustrated) spreads into the n--type semiconductor layer 301a, and accordingly, the SBD results in having a high withstand voltage. In addition, when a forward bias has been applied, electrons flow from the ohmic electrode 303 to the Schottky electrode 302. Accordingly, the SBD according to the present invention is excellent for high withstand voltage and large current, has a high switching speed, and is excellent also in withstand voltage and reliability.

FIG. 19 shows an example of a HEMT (high electron mobility transistor) according to the present invention. The HEMT 400 includes an n-type semiconductor layer 401 having a wide band gap, an n-type semiconductor layer 402 having a narrow band gap, an n+-type semiconductor layer 403, a semi-insulating layer 404, a stress relief layer 405, a gate electrode 406, a source electrode 407, and a drain electrode 408.

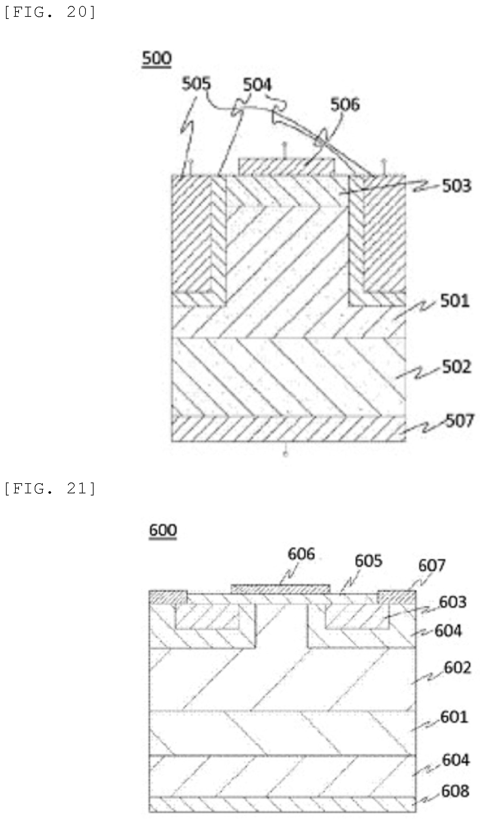

FIG. 20 shows an example of a MOSFET (semiconductor field-effect transistor) according to the present invention. The MOSFET 500 includes an n--type semiconductor layer 501, n+-type semiconductor layers 502 and 503, gate insulating films 504, gate electrodes 505, a source electrode 506, and a drain electrode 507.

FIG. 21 shows an example of an IGBT (insulated gate bipolar transistor) according to the present invention. The IGBT 600 includes an n-type semiconductor layer 601, an n--type semiconductor layer 602, an n+-type semiconductor layer 603, a p-type semiconductor layer 604, a gate insulating film 605, a gate electrode 606, an emitter electrode 607, and a collector electrode 608.

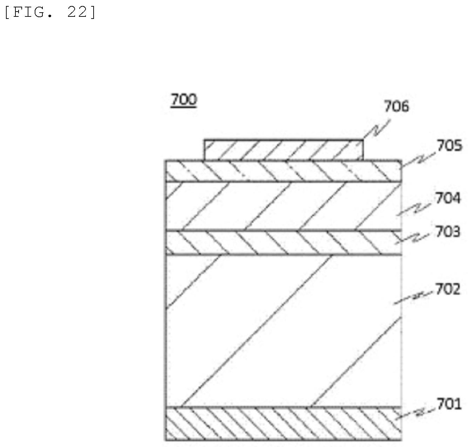

FIG. 22 shows an example of an LED (light emitting diode) according to the present invention. The LED 700 includes a first electrode 701, an n-type semiconductor layer 702, a light-emitting layer 703, a p-type semiconductor layer 704, a translucent electrode 705, and a second electrode 706.

Examples of the material of the translucent electrode include an electroconductive material of an oxide containing indium or titanium, etc. More specific examples thereof include In₂O₃, ZnO, SnO₂, Ga₂O₃, TiO₂, CeO₂, a mixed crystal of two or more thereof, and doped versions thereof. The translucent electrode can be formed by providing these materials with a known means such as sputtering. In addition, after the translucent electrode has been formed, the translucent electrode may be subjected to thermal annealing for the purpose of transparency.

Examples of the material of the first electrode 701 and the second electrode 706 include: metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium and silver, or alloys thereof; electroconductive films of metal oxides such as tin oxide, zinc oxide, rhenium oxide, indium oxide, indium tin oxide (ITO), and indium zinc oxide (IZO); organic electroconductive compounds such as polyaniline, polythiophene and polypyrrole; and mixtures thereof.

A method for forming the film of the electrode is not particularly limited, and the electrode can be formed on the above substrate according to a method appropriately selected in consideration of suitability for the above material, from: a wet method such as a printing method, a spray method or a coating method; a physical method such as a vacuum deposition method, a sputtering method or an ion plating method; a chemical method such as CVD or a plasma CVD method; and the like.

### (Film forming method)

Next, a film forming method of the present invention will be described. A method for forming the film of the present invention is a film forming method including steps of: generating mist by atomizing or dropletizing a raw material solution; transporting the mist to a film forming unit by a carrier gas; and forming a film on a base body by supplying the mist to the base body through a nozzle in the film forming unit, and subjecting the mist to heat treatment on the base body; in which in the step of forming the film on the base body, the mist in the nozzle is irradiated with microwaves in a multimode manner to heat the mist.

According to such a film forming method, it is possible to heat selectively and rapidly only the mist among the mist and the carrier gas supplied to the base body, thereby suppressing the evaporation of the mist without increasing the saturated water vapor pressure of the carrier gas, and thus enhancing the film forming rate while inhibiting foreign substances and abnormal growth. Furthermore, it is possible to supply the mist of high temperature to the base body, and accordingly, the temperature drop of the base body is suppressed even if the supply amount of the mist is increased; and it becomes possible to form the film at a high film forming rate without damaging the crystallinity even on the base body having a large diameter. Furthermore, it is possible to form a film having excellent in-plane uniformity of the film thickness, by having a nozzle for straightening the flow of the mist provided therein and heating the mist in the nozzle, and it is also possible to simultaneously form films on a plurality of base bodies and improve productivity by being capable of heating a large amount of mist.

Embodiments of a film forming method of the present invention will be described below, with reference to an example of a film forming method using a film forming apparatus 100 according to the present invention shown in FIG. 1.

First, a base body (crystalline substrate) 110 is placed on a hot plate 108, and the hot plate 108 is operated. Flow-rate adjusting valves 103a and 103b are opened to supply the carrier gas from a carrier gas source 102a (main carrier gas) and a carrier gas source for dilution 102b (carrier gas for dilution) into a film forming chamber 107 through a transport unit 109, an atmosphere of the film forming chamber 107 is sufficiently replaced with the carrier gas, and the flow rates of the main carrier gas and the carrier gas for dilution are each adjusted and controlled.

### [Step of atomizing or dropletizing raw material solution to generate mist]

The raw material solution 104a is accommodated in a mist generating source 104 of a misting unit 120, an ultrasonic vibrator 106 is vibrated, the vibration is propagated to the raw material solution 104a through water 105a, and thereby the raw material solution 104a is atomized or dropletized to generate mist.

As the raw material solution 104a, it is preferable to use a solution containing a metallic raw material and at least one type of solvent selected from water, methanol, ethanol, ethylene glycol, diethylene glycol, propylene glycol, tetraethylene glycol, glycerol, benzyl alcohol, and dipropylene glycol.

By using such a solvent, it becomes possible to selectively and rapidly heat the mist by microwave heating.

The raw material solution (aqueous solution) 104a is not particularly limited as long as the solution contains a material that can be misted, and may be an inorganic material or an organic material. As the raw material solution 104a, a solution of a metal or a metallic compound is suitably used; and it is possible to use a solution containing one or more metals selected from the group consisting of gallium, iron, indium, aluminum, vanadium, titanium, chromium, rhodium, nickel and cobalt, but it is preferable to use a solution particularly containing Ga.

Thereby, it is possible to stably produce an α-Ga₂O₃ film.

The raw material solution 104a is not particularly limited as long as the solution can mist the above metal solution, but as the raw material solution 104a, it is possible to suitably use a solution in which a metal is dissolved or dispersed in a form of a complex or a salt in an organic solvent or water. Examples of the form of the complex include an acetylacetonate complex, a carbonyl complex, an ammine complex, and a hydride complex. Examples of the form of the salt include a metal chloride salt, a metal bromide salt, and a metal iodide salt.

In addition, it is possible to use also a solution in which the above metal is dissolved in hydrobromic acid, hydrochloric acid, hydroiodic acid or the like, as an aqueous solution of a salt. It is preferable for the concentration of solutes to be 0.01 to 1 mol/L, is more preferable to be 0.05 to 0.5 mol/L, and is further preferable to be 0.08 to 0.30 mol/L. When the concentration is within such a range, it is possible to efficiently prevent a decrease in the film forming rate, and contamination of foreign substances and abnormal growth due to a side reaction and deposition of an excessive amount of the raw material.

The solvent for dissolving the metallic raw material in the present invention has microwave absorbing properties, and it is possible to use acidic solvents such as acetic acid, nitric acid and formic acid, basic solvents such as an aqueous sodium hydroxide solution, an aqueous potassium hydroxide solution and ammonia water, and the like, in addition to water and alcohols such as methanol, ethanol, ethylene glycol, diethylene glycol, propylene glycol, tetraethylene glycol, glycerol, benzyl alcohol and dipropylene glycol described above. Among the solvents, it is particularly preferable to use a solvent containing water as a main component. When the solvent contains water as the main component, the solvent resists making impurities derived from the solvent remain in the film, is excellent in the atomization efficiency, and is advantageous also in terms of cost.

Note that in the present invention, the "main component" is a component having the highest content with respect to all components, and means that the content is preferably 50% by mass or more, more preferably 70% by mass or more, further preferably 90% by mass or more, and may also be 100% by mass.

In addition, an additive agent such as a substance containing a halogen (for example, hydrohalic acid), an oxidizing agent, and the like may be mixed to the raw material solution 104a. Examples of the hydrohalic acid include hydrobromic acid, hydrochloric acid, hydroiodic acid and the like, and among the acids, hydrobromic acid or hydroiodic acid is preferable. Examples of the oxidizing agent include peroxides such as hydrogen peroxide (H₂O₂), sodium peroxide (Na₂O₂), barium peroxide (BaO₂), benzoyl peroxide (C₆H₅CO)₂O₂, and the like; and organic peroxides such as hypochlorous acid (HClO), perchloric acid, nitric acid, ozone water, peracetic acid, nitrobenzene, and the like.

Furthermore, when the film to be formed is a semiconductor, the raw material solution 104a may contain a dopant. The dopant is not particularly limited. Examples thereof include n-type dopants such as tin, germanium, silicon, titanium, zirconium, vanadium and niobium, and p-type dopants such as copper, silver, tin, iridium and rhodium. The concentration of the dopant may be, for example, about 1.0×10⁻⁹ to 1.0 mol/L, and may be set to a low concentration of about 1.0×10⁻⁷ mol/L or lower, or also to a high concentration of about 0.01 mol/L or higher.

Note that when a crystalline metal oxide film formed of two or more types of metals (for example, an α-(AlₓGa₁₋ₓ)₂O₃ film (0≤X<1)) is formed, a raw material solution, in which each of metallic raw material solutions is separately mixed, may be accommodated and misted in the mist generating source 104 in one misting unit 120, or a plurality of misting units may be provided, and the respective metallic raw material solutions may be misted in the respective misting units. When a plurality of misting units have been provided, a mist mixer (not illustrated) may be provided for mixing each of the raw material solutions which have been misted, or also the mist may be separately supplied to the film forming chamber 107 without providing the mist mixer.

### [Step of transporting mist to film forming unit by carrier gas]

In the step of transporting the mist to the film forming unit by the carrier gas, the mist is transported from the misting unit 120 to the film forming unit 140 via the transport unit 109 by the carrier gas, and is introduced into the film forming chamber 107. The mist which is transported by the carrier gas simultaneously passes through the microwave heating device 200 which is arranged in the film forming unit 140.

### [Step of supplying mist to base body through nozzle in film forming unit, performing heat treatment on base body, and forming film on base body]

In the microwave heating device 200, microwaves (2.45 GHz) generated by the microwave oscillator 201 are propagated through the waveguide 205, and the nozzle 150, which is arranged in the applicator 204 and through which the mist 220 and the carrier gas pass, is irradiated with the microwaves. Alternatively, it is also acceptable to measure the temperature of the outlet portion of the applicator 204 of the nozzle 150 with an optical fiber thermometer 207, and automatically adjust the output of the microwave oscillator 201 as appropriate so that the measured temperature becomes constant.

In general, in order to improve the film forming rate in the mist CVD method, it is necessary to increase the supply amount of the mist. However, when a large amount of mist is supplied, the temperature of the base body 110 is lowered, and the crystallinity of the film is lowered. On the other hand, by performing the microwave heating of the present invention, a high-temperature mist can be supplied onto the base body 110, and accordingly, the heat can be suppressed from being taken away from the base body 110; and it becomes possible to improve the film forming rate while suppressing the lowering of the crystallinity.

Furthermore, in the heat transfer heating using a heater or the like, the temperature of not only the mist but also the carrier gas rises, and accordingly, the saturated vapor pressure increases and the evaporation of the mist is promoted. Because of this, the raw material in the mist tends to be easily deposited, adheres or is embedded in the film as a foreign substance, and causes the lowering of the film quality. On the other hand, in the case of microwave heating of the present invention, it is possible to directly heat the mist 220 without warming the carrier gas. As a result, the saturated vapor pressure does not increase, and it is possible to raise the temperature of the mist without promoting the evaporation of the mist, and improve the film forming rate without lowering the film quality.

In addition, at this time, it becomes possible to emit microwaves to a large space, by performing microwave heating in a multimode manner, and accordingly, it becomes possible to provide a member for straightening the flow of the mist such as a nozzle 150; or it becomes possible to heat a large amount of mist, supply the heated mist to a plurality of base bodies at the same time, and form a film, which is excellent also in productivity.

A method of controlling the microwave output is not particularly limited. The output may be kept constant, or the temperature of the nozzle 150 may be measured to feedback the temperature so as to become constant, and automatically adjust the output, but it is more preferable to control the temperature. This is because the temperature of the heated portion resists varying with time.

Note that the method for measuring the temperature is not particularly limited, but in the case of measuring the temperature of the microwave emitting portion, it is recommended to use an infrared radiation thermometer, an optical fiber thermometer or the like depending on a measurement target, in order to suppress the thermometer 207 from absorbing microwaves. Note that it is preferable that the temperature measuring portion of the optical fiber thermometer to be used at this time is formed from a microwave-transmissive material such as a non-metallic material.

The irradiation intensity of the microwaves is not particularly limited and may be appropriately selected depending on the raw material solution, but in the case where the mist is heated, it is preferable for the irradiation intensity to be 0.1 mW to 20 kW, and is more preferable to be 1 mW to 500 W. When the irradiation intensity is in the range of 0.1 mW to 20 kW, it is possible to effectively heat the mist, and effectively suppress the electric discharge in the applicator 204.

In addition, the frequency of the microwaves is not particularly limited. The frequency can be appropriately selected depending on the physical properties of the raw material solution. For example, when water is the solvent, it is preferable to set the frequency to 0.9 GHz or higher and 300 GHz or lower, at which water can absorb the microwaves.

When the frequency is in this range, it is possible to stably heat the mist, and keep the penetration depth of the microwaves to an appropriate length, and uniformly heat even the inside of the mist.

It is particularly preferable to set the frequency of the microwaves to 2.45 GHz or higher and 25 GHz or lower.

When the frequency is in this range, it is possible to more stably heat the mist, and keep the penetration depth of the microwaves to an appropriate length, and more uniformly heat even the inside of the mist.

The mist heated as described above is supplied to the base body 110 placed on the hot plate 108, and is subjected to heat treatment (thermal reaction) by the heat of the hot plate 108 in the film forming chamber 107, and a film is formed on the base body 110.

The base body 110 is not particularly limited as long as the base body can have a film formed thereon and support the film. The base body may be a known base body. The base body may be an insulator, a conductor, a semiconductor, a single crystal, or a polycrystal. Examples of the material include: polysulfone, polyethersulfone, polyphenylene sulfide, polyether ether ketone, polyimide, polyetherimide, and a fluororesin; metals such as iron, aluminum, stainless steel, and gold; and silicon, sapphire, quartz, glass, gallium oxide, lithium niobate and lithium tantalate; but the examples are not limited to these substances.

In addition, it is preferable to use a base body 110 in which aluminum is the main component metal element contained in the largest amount, among the metal elements contained in the base body 110. In particular, it is preferable to use a sapphire wafer, from the viewpoint of quality and cost.

The plane orientation of the principal plane of the base body 110 is not particularly limited, and in the case of the sapphire wafer, a main surface, for example, such as a c-plane, an m-plane or an a-plane can be used. In addition, the principal plane may have an off-angle with respect to the just surface. The off-angle is not particularly limited, but is preferably 0° to 15°.

The thickness of the base body 110 is not particularly limited, but is preferably about 200 to 800 µm from the viewpoint of cost.

In addition, it is recommended that the film-forming surface of the base body 110 has a diameter of about 10 cm (4 inches) or larger, and it is more preferable that the diameter is about 15 cm (6 inches) or larger. The upper limit size of the film-forming surface of the base body 110 is not particularly limited, but the diameter can be, for example, 30 cm (12 inches).

When the base body 110 is set to have a large diameter in this way, the crystalline metal oxide film formed on the base body 110 can be formed to have further higher quality and higher productivity.

A shape of the base body 110 is not particularly limited in the present invention.

The base body 110 may be placed on the top surface of the film forming chamber 107 to be laid face down, or the base body 110 may be placed on the bottom surface of the film forming chamber 107 to be laid face up.

As for the heat treatment (thermal reaction) of the mist supplied onto the base body 110, the mist may react by heating, and the reaction conditions and the like are not particularly limited. The reaction conditions and the like can be appropriately set depending on the raw material and the film to be formed. For example, it is preferable for the heating temperature to be in a range of 120°C to 600°C, is more preferable to be in a range of 200°C to 600°C, and is further preferable to be in a range of 400°C to 550°C.

The heat treatment (thermal reaction) may be performed in any atmosphere of a vacuum, a non-oxygen atmosphere, a reducing gas atmosphere, an air atmosphere and an oxygen atmosphere, and may be appropriately set depending on the film to be formed. In addition, the film may be formed under any condition of reaction pressure, that is, under an atmospheric pressure, an elevated pressure, or reduced pressure, but it is preferable that the film is formed under the atmospheric pressure, because the apparatus configuration can be simplified.

The film may be formed directly on the base body 110, or may be layered on an intermediate layer (buffer film or release film) which has been formed on the base body 110. The intermediate layer is not particularly limited as long as the composition is a metal oxide capable of forming a corundum structure, and can contain an oxide containing any one of, for example, aluminum, titanium, vanadium, chromium, iron, gallium, rhodium, indium and iridium, as a main component.

More specifically, the intermediate layer is Al₂O₃, Ti₂O₃, V₂O₃, Cr₂O₃, Fe₂O₃, Ga₂O₃, Rh₂O₃, In₂O₃, and Ir₂O₃, and may be a metal oxide of a binary system represented by (AₓB₁₋ₓ)₂O₃ (0<x<1) when two elements selected from the above metallic elements are determined as A and B, or a metal oxide of a ternary system represented by (AₓB_{y}C_{1-x-y})₂O₃(0<x<1, 0<y<1) when three elements selected from the above metallic elements are determined as A, B and C.

In addition, in the step of forming the film on the base body 110, the film can be formed on the base body 110 while the base body 110 is being moved.

The direction in which the base body 110 is moved is not particularly limited. There are methods: a method in which a moving stage 161a is provided on which the base body 110 and the hot plate 108 are placed and the base body 110 and the hot plate 108 are moved back and forth below the nozzle 150 as shown in FIG. 5, and a method in which the base body 110 and the hot plate 108 are rotationally moved below the nozzle 150 by the moving stage 161b on which the base body 110 and the hot plate 108 are placed as shown in FIG. 6. In addition, at this time, a mechanism for rotating the base body 110 may be provided to rotate the base body 110.

By forming a film while moving the base body 110 as in this way, it is possible to produce a film having more improved uniformity.

In the present invention, annealing treatment may be performed after the film has been formed. The temperature of the annealing treatment is not particularly limited, but is preferable to be 600°C or lower, and is more preferable to be 550°C or lower. This is because the crystallinity of the film is not impaired. The treatment time of the annealing treatment is not particularly limited, but is preferable to be 10 seconds to 10 hours, and is more preferable to be 10 seconds to 1 hour.

The crystalline metal oxide film formed according to the above method may be delaminated off from the base body 110. The delaminating method is not particularly limited, and may be a known method. Examples of the method include a method of delaminating by applying a mechanical impact, a method of delaminating by applying heat and utilizing the thermal stress, a method of delaminating by applying vibration such as ultrasonic waves, a method of delaminating by etching, and laser lift-off. The crystalline metal oxide film can be obtained as a self-supporting film by the delaminating.

Electrodes necessary for constituting a semiconductor device can be formed by a general method. Specifically, any of vapor deposition, sputtering, CVD, plating, and a printing method of bonding together with a resin or the like may be used. As the electrode material, any of materials may be used which include: metals such as Al, Ag, Ti, Pd, Au, Cu, Cr, Fe, W, Ta, Nb, Mn, Mo, Hf, Co, Zr, Sn, Pt, V, Ni, Ir, Zn, In and Nd; electroconductive films of metal oxides such as tin oxide, zinc oxide, indium oxide, indium tin oxide (ITO) and indium zinc oxide (IZO); and organic electroconductive compounds such as polyaniline, polythiophene and polypyrrole; and alloys or mixtures of two or more of these types may also be used. It is preferable for a thickness of the electrode to be 1 to 1000 nm, and is more preferable to be 10 to 500 nm.

### EXAMPLE

The present invention will be described in detail with reference to Examples, but the present invention is not limited thereto.

### (Example 1)

Gallium iodide was added to water, and an aqueous solution of 0.1 mol/L was prepared, and was determined as a raw material solution 104a. The raw material solution 104a obtained as described above was accommodated in a mist generating source 104. The temperature of the solution at this time was 25°C.

As a base body 110, a sapphire substrate of 4-inch and c-plane was placed on a hot plate 108 in a film forming chamber 107, and the hot plate 108 was operated to raise the temperature of the base body 110 to 500°C.

Flow-rate adjusting valves 103a and 103b were opened, nitrogen gas was supplied as a carrier gas into the film forming chamber 107 from a carrier gas source 102a (main carrier gas) and a carrier gas source for dilution 102b (carrier gas for dilution), and an atmosphere of the film forming chamber 107 was sufficiently replaced with the carrier gases; and at the same time, the flow rate of the main carrier gas was adjusted to 12 L/min and the flow rate of the carrier gas for dilution was adjusted to 12 L/min, respectively.

Next, an ultrasonic vibrator 106 was vibrated at 2.4 MHz, and the vibration was propagated to the raw material solution 104a through water 105a, and thereby, the raw material solution 104a was misted to generate mist.

The mist was transported to a nozzle 150 through a supply pipe 109a by the carrier gas, and was irradiated with microwaves (2.45GHz) in a microwave heating device 200, and the heated mist was supplied to the base body 110. At this time, the nozzle 150 was formed from quartz, a nozzle discharge surface 152 was set to a rectangle having a long side 120 mm and a short side 5 mm, and a wall thickness of the nozzle was set to 2 mm. In addition, the nozzle discharge surface 152 and the surface of the base body 110 were arranged parallel to each other, and spaced apart from each other by 2.5 cm.

The nozzle 150 and the applicator 204 were installed so that the nozzle 150 penetrated the applicator 204 as shown in FIGS. 7 and 8. At this time, a ratio V/Q of a volume V [cm³] of the nozzle to a flow rate Q [cm³/s] of the carrier gas was 1.

In addition, an output of the microwaves was controlled so that the temperature measured by an optical fiber thermometer was kept constant at 40°C.

Then, a film of α-Ga₂O₃ having a corundum structure was formed on the base body 110, on the condition of 500°C under the atmospheric pressure, by subjecting the mist to a thermal reaction while reciprocating the base body 110 at a lower portion of the nozzle 150 by a base body moving mechanism as shown in FIG. 5 in the film forming chamber 107, and while exhausting the gas from an exhaust port 112. The film formation time at this time was set to 1 hour, and the base body 110 was moved so that the base body 110 passed under the nozzle 150 once per minute. Furthermore, during the film forming process, the raw material solution 104a in the mist generating source 104 was replenished as appropriate in the mist generating source 104 with the use of a replenishing mechanism (not illustrated) so that the height of the water surface of the raw material solution 104a became constant during the film formation.

### (Example 2)

A film was formed on the same conditions as in Example 1, except that the nozzle discharge surface 152 was circular with an inner diameter of 30 mm, the wall thickness of the nozzle 150 was set at 2 mm, and a cavity resonator having a cylindrical internal space with a diameter of 91 mm was used as the applicator 204.

### (Comparative Example 1)

A film was formed on the same conditions as in Example 1, except that a film forming apparatus was used which did not include the microwave irradiation device 200, the irradiation with microwaves was not performed, and the film formation time was set to 2 hours.

### (Comparative Example 2)

A film was formed on the same conditions as in Example 1, except that a film forming apparatus was used which did not include the microwave irradiation device 200, and the whole of the supply pipe 109a was heated at a preset temperature of 40°C by a ribbon heater, without irradiation with microwaves.

### (Example 3)

A film was formed on the same conditions as in Example 1, except that gallium acetylacetonate was dissolved as the raw material in an aqueous hydrochloric acid solution (1.0 vol%) and an aqueous solution of 0.1 mol/L was prepared and used as the raw material solution 104a, that the flow rates of the main carrier gas and the diluting carrier gas were adjusted to 18 L/min and 6 L/min, respectively, that a sapphire substrate of 6 inches was used as the base body 110, and that the output of microwaves was controlled so that the temperature of the optical fiber thermometer became 50°C.

### (Comparative Example 3)

A film was formed on the same conditions as in Example 3, except that a film forming apparatus was used which did not include the microwave irradiation device 200 and the microwave irradiation was not performed.

### (Example 4)

A film was formed on the same conditions as in Example 1, except that gallium acetylacetonate was dissolved as the raw material in an aqueous hydrochloric acid solution (1.0 vol%) and an aqueous solution of 0.1 mol/L was prepared, then 10 vol% of formic acid was added thereto, and was used as the raw material solution 104a, that the flow rates of the main carrier gas and the diluting carrier gas were adjusted to 24 L/min and 0 L/min, respectively, that a sapphire substrate of 8 inches was used as the base body 110, and that the output of microwaves was controlled so that the temperature of the optical fiber thermometer became 75°C.

### [Evaluation 1: film thickness measurement]

Film thicknesses of the films produced in Examples 1 to 4 and Comparative Examples 1 to 3 were each measured with the use of an optical interferometric film thickness meter F50. In a polar coordinate system (r, θ) in which the center of the base body was determined as the origin, when a radius of the base body was represented by R, the measurement points were set to 25 points which were expressed by:
r= 0, R/4, R/2, and 3R/4; and
θ= 0, π/4, π/2, 3π/4, π, 5π/4, 3π/2, 7π/4, and 2π.

With the use of the maximum film thickness D_{Max}, the minimum film thickness D_{Min}, and the mean film thickness D_{Ave} among the above measurement points, the film thickness distribution χ[%] was calculated according to the following expression.$χ = \frac{\left({D}_{Max}-{D}_{Min}\right)}{2 {D}_{Ave}} \times 100$

In addition, the film forming rate was calculated from the mean film thickness D_{Ave}. The film forming rate was calculated as mean film thickness _{Ave} (µm) ÷ the film formation time (hour) = the film forming rate (µm/hour).

### [Evaluation 2: crystal structure and crystallinity evaluation]

The crystalline structure of the produced film was evaluated by XRD 2θ-ω scan. The films produced in Examples 1 to 4 and Comparative Examples 1 to 3 were confirmed to be α-Ga₂O₃.

After that, the rocking curve of the (006) plane was measured, and the half width of the (006) plane was measured.

### [Evaluation 3: measurement of number of foreign substances and number of abnormal growth portions]

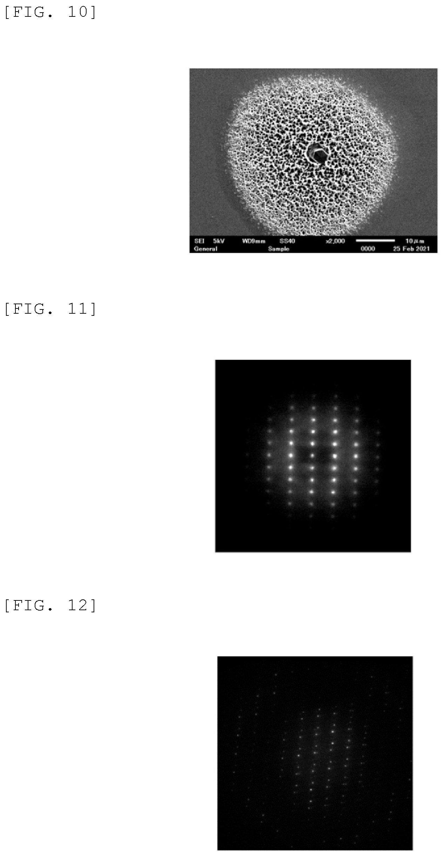

The number of foreign substances in the crystalline metal oxide films formed in Examples 1 to 4 and Comparative Examples 1 to 3 was counted in a dark visual field image at a magnification of 20 times, with the use of an optical microscope. The total field-of-view area of 0.1 to 1 cm² was observed, and the number of foreign substances (= foreign substance density) in 1 cm² was calculated. An example of the observed foreign substance is shown in FIG. 9, and an example of the abnormal growth portion is shown in FIG. 10.

The foreign substance in FIG. 9 is considered to be a deposition of a raw material, which has been formed by evaporation of the mist before the mist reaches the base body. The number of the foreign substances can be measured by an electron microscope such as SEM, a surface inspection instrument that detects a defect using difference in scattered light intensity, a surface inspection device which images with a microscope and classifies the foreign substances by machine learning, or the like, in addition to being capable of observing the foreign substances as bright spots in a dark visual field of a microscope as described above. In the present evaluation, particles of 0.01 µm to 10 µm were counted as foreign substances.

As shown in FIG. 10, the abnormal growth portion was a circular shape having a diameter of 10 to 100 µm, and a crystal other than the α phase was observed in a vicinity of the center. The cross section of the abnormal growth portion was analyzed, and as a result, a foreign substance having a size of up to several micrometers was observed in the lower portion of the abnormal growth portion, and a region which was considered to be a crystal phase existed in an upper portion of the foreign substance. Performing analysis by electron beam diffractometry, the electron beam diffraction image of the flat region outside the abnormal growth portion in FIG. 10 was an electron beam diffraction image of α-Ga₂O₃ as shown in FIG. 11, but on the other hand, the electron beam diffraction image of the crystalline portion in the region above the foreign substance, which was considered to be a crystalline phase in FIG. 10, became an electron beam diffraction image of being different from the α-Ga₂O₃ as shown in FIG. 12. This is considered to be because another crystal phase of the Ga₂O₃ (which is considered to be γ) has been formed starting from a foreign substance. Note that the conditions of the electron beam diffraction were as follows.

Selected area electron beam diffraction method Transmission electron microscope:
   manufactured by Hitachi High-Technologies Corporation H-9500
Acceleration voltage: 300 kV
Camera length: 1.0 m
Selected area: approximately 140 nm φ

The abnormal growth portion can be observed as a bright spot in a dark field image of a microscope, and the number thereof can be measured by an electron microscope such as SEM, a surface inspection instrument that detects defects by using a difference in scattered light intensity, a surface inspection device that images with a microscope and classifies by machine learning, and the like; and whether or not the abnormal growth portion is a γ phase can be determined by crystal orientation analysis such as an EBSD method.

The results of the above Evaluations 1 to 3 are summarized in Table 1.

**[Table 1]**

| # | Heating method | Temperature [°C] | Substrate diameter [inch] | Film thickness distribution [ ± %] | Film forming rate [ *µ* m/h] | (006) Half width [s] | Foreign substance [/cm²] | Abnormal growth [/cm²] |
|---|---|---|---|---|---|---|---|---|
| Example 1 | Microwave nozzle | 40 | 4 | 2.5 | 5.6 | 7.8 | < 1 | < 1 |
| Example 2 | Microwave nozzle | 40 | 4 | 4.6 | 6.2 | 8.5 | < 1 | < 1 |
| Comparative Example 1 | No heating | 20 | 4 | 8.4 | 3 | 19.1 | 48 | 56 |
| Comparative Example 2 | Heater supply pipe | 40 | 4 | 10.2 | 3.6 | 28.4 | 247 | 174 |
| Example 3 | Microwave nozzle | 50 | 6 | 2.8 | 5.4 | 8.4 | < 1 | < 1 |
| Comparative Example 3 | No heating | 20 | 6 | 7.8 | 1.8 | 26.1 | 59 | 447 |
| Example 4 | Microwave nozzle | 75 | 8 | 2.2 | 5.2 | 7.3 | < 1 | < 1 |

### [Evaluation 3-2: measurement of particle size distribution of foreign substance]

For the crystalline metal oxide films produced in Example 1 and Comparative Example 1, a machine learning type of surface inspection device equipped with a confocal microscope was used to detect foreign substances observed from the surface direction of the film, and the particle size of the foreign substance was measured with the use of a review function for the detected foreign substances to create a particle size distribution of the foreign substances.

The particle size here refers to a circle-equivalent diameter in a two-dimensional image observed from the surface direction of the crystalline metal oxide film. The circle-equivalent diameter is a diameter of a circle having an area equivalent to an area of a particle captured in the two-dimensional image, and the particle area can be calculated by image analysis. The same measurement can be performed, for example, with OptelicsAI² manufactured by Lasertec Corporation, etc. The results are shown in Table 2.

As shown in Table 2, the mode value of the particle size of the foreign substances in Example 1 was 0.225 µm, and a particle of 0.5 µm or larger was not observed. The particle size (D50) was 0.225 µm, at which a cumulative frequency became 50%. In addition, the standard deviation σ was 0.08 µm. In addition, a ratio (D90/D10) of the particle size (D90) at which the cumulative frequency was 90%, to the particle size (D10) at which the cumulative frequency was 10% was 2.6.

In addition, a foreign substance density was 0.4/cm², which was a ratio of the particle number of the foreign substances to the observation area. A ratio of the foreign substances having a particle size of (particle size D50 - standard deviation σ) or larger and (particle size D50 + standard deviation σ) or smaller, to the total number of the foreign substances was 75%.

In Comparative Example 1, larger particles than those in Example 1 were observed. The mode value of the particle sizes of the foreign substances was 3.25 µm. The particle size (D50) was 2.75 µm, at which the cumulative frequency became 50%. In addition, the standard deviation was 1.25 µm. In addition, a ratio (D90/D10) of the particle size (D90) at which the cumulative frequency was 90% to the particle size (D10) at which the cumulative frequency was 10% was 5.7.

The foreign substance density was 47.8/cm², which was a ratio of the particle number of the foreign substance to the observation area. A ratio of the foreign substances having a particle size of (particle size D50 - standard deviation σ) or larger and (particle size D50 + standard deviation σ) or smaller, to the total number of the foreign substances was 59%.

It is understood from the comparison between Example 1 and Comparative Example 1 that Example 1 in which the mist was irradiated with microwaves has a small amount of foreign substances and a small variation in the particle size of the foreign substances. When a semiconductor device has been manufactured with the use of the crystalline metal oxide film having a small amount of foreign substances and a small variation in the particle size of the foreign substances as in Example 1, the influence of the foreign substances on the device characteristics becomes minor as will be described later.

### (Example 5)

The crystalline metal oxide films produced in Example 1 and Comparative Example 1 were measured for the in-plane distribution of foreign substances with the use of a machine learning type of surface inspection device.

Specifically, the whole surface of a wafer surface was automatically photographed at 2 mm intervals with an imaging camera, by operations of: using an automatic inspection device including a microscope, an electric XY stage on which a wafer to be observed was placed and which was electrically movable in the XY direction, the imaging camera such as a digital camera, and a controller for controlling the automatic inspection device; and setting a coordinate so that the center of the substrate became the origin; and controlling the electric XY stage so that the visual field size of the microscopic image became 1×1 mm. For example, in the case of a wafer having a diameter of 4 inches, 1789 (=17.89 cm²) microscopic images were automatically photographed. The total of the field-of-view areas was 22.8% of the area of the surface of the crystalline metal oxide film.

The number of foreign substances was determined for the automatically photographed images, and the microscopic images were classified.

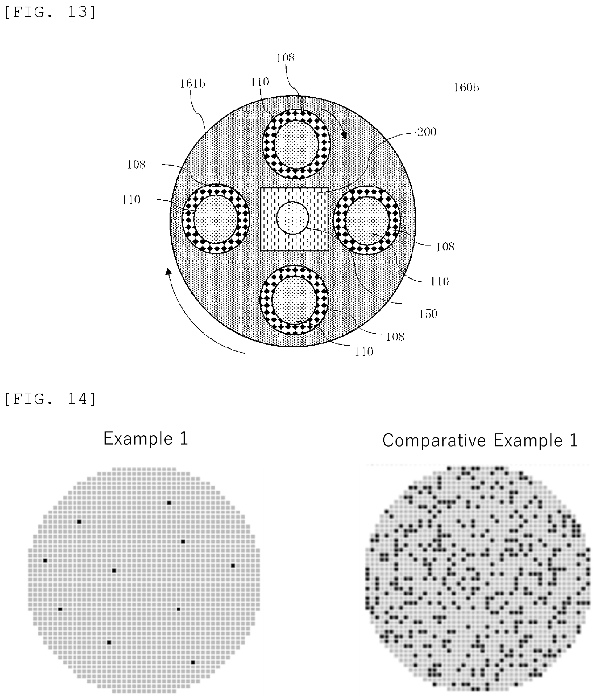

FIG. 14 shows a foreign substance map in which a portion at which a foreign substance has been observed under a microscope is shown by a black color, and a portion at which the foreign substance has not been observed is shown by a white color.

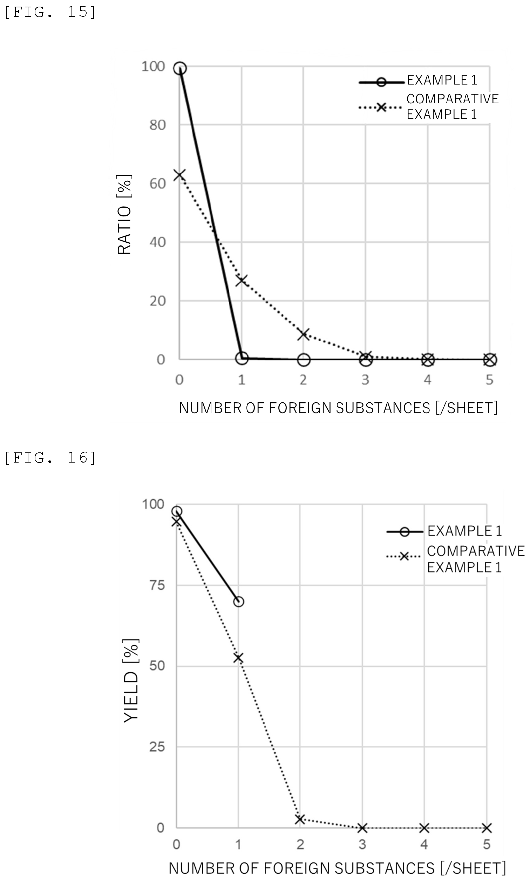

Subsequently, the microscopic images determined to have the foreign substance were classified according to the number of foreign substances in each microscopic image. In the present invention, a foreign substance that was not fully seen was also counted as one. The results of having counted the number of foreign substances observed in the microscopic images are shown in FIG. 15.

In Example 1, the microscopic images in which the foreign substance was not observed accounted for 99.4% of the total; the microscopic images in which one foreign substance was observed accounted for 0.6% of the total; and the microscopic images in which two or more foreign substances were observed accounted for 0%. The foreign substance density was calculated also from the present measurement, and as a result, was 0.5/cm² in Example 1.

In Comparative Example 1, the microscopic images in which the foreign substance was not observed accounted for 63.0% of the total; the microscopic images in which one foreign substance was observed accounted for 27.0% of the total; and the microscopic images in which two or more foreign substances were observed accounted for 10.0%. In addition, the foreign substance density was calculated also from the present measurement, and as a result, was 48.7/cm².

According to the comparison between Example 1 and Comparative Example 1, it is understood that in Example 1 in which the mist was irradiated with microwaves, the variation in the position at which the foreign substance was generated was small, and the foreign substance was less generated at the same position. When a semiconductor device has been manufactured with the use of the crystalline metal oxide film like this, the influence of the foreign substances on the device characteristics becomes minor as will be described later.

### [Evaluation 4: electrical characteristics evaluation]

An SBD of a semiconductor device was produced in the 1×1 mm portion captured in Example 5, on the crystalline metal oxide films formed in Example 1 and Comparative Example 1.

The current-voltage characteristics of the obtained semiconductor device were evaluated. The voltage at which dielectric breakdown occurs was examined by measurement of the current-voltage characteristics in the reverse direction. A semiconductor device having a withstand voltage of 600 V or higher was determined as an acceptable product, and a yield was calculated according to the expression: the number of acceptable products / the total number of manufactured semiconductor devices = yield [%]. The yield of Example 1 was 98%, and the yield of the film of Comparative Example 1 was 44.9%.

In the film produced in Comparative Example 1, the foreign substance having a large size unevenly exists, accordingly, the influence on the device characteristics is large, and the yield is in a low value of less than 50%. On the other hand, in the film produced in Example 1, the foreign substance was small, and the deviation of the position of the foreign substance was small; and accordingly, an influence on the device characteristics was small, and the yield was as high as 95% or higher.

FIG. 16 shows the results of having subsequently plotted the yield for each number of foreign substances in one microscopic image captured in Example 5. Here, the number of the semiconductor devices was counted by removing the devices in which the abnormal growth portion as shown in FIG. 10 was observed, from all the semiconductor devices (1789 pieces) manufactured in the present evaluation. Note that the yield of the device having the abnormal growth portion as shown in FIG. 10 was 0%.

It is understood that when a foreign substance is contained in the film, the yield is rapidly lowered, and particularly when two or more foreign substances are contained, the film is substantially rejected.

**[Table 2]**

| | Example 1 | Comparative Example 1 |
|---|---|---|
| Mode value [ *µ* m] | 0.225 | 3.25 |
| Standard deviation [*µ* m] | 0.08 | 1.25 |
| Index of particle size distribution (D90/D10) [-] | 2.6 | 5.7 |
| D10 [µm] | 0.125 | 0.75 |
| D50 [µm] | 0.225 | 2.75 |
| D90 [µm] | 0.325 | 4.25 |

### (Example 6)

A film was formed on the same conditions as in Example 1, except that the film forming apparatus 100 was used which included the rotary moving mechanism 160b that rotated and revolved the base body as shown in FIG. 13, four sapphire substrates of 4 inches were provided on the moving mechanism 160b, the nozzle 150 was made from quartz, the nozzle discharge surface 152 was a circular shape with an inner diameter of 50 mm, the wall thickness of the nozzle was 2 mm, and the flow rates of the main and diluting carrier gases were adjusted to 50 L/min and 10 L/min, respectively.

The above evaluation on film thickness and crystallinity of each of the four samples after film formation was conducted, and as a result, the variation in the measured values of the four samples was within about 3%. Note that the variation referred to herein is an index represented by (maximum value - minimum value) / (maximum value + minimum value) × 100 (%).

Subsequently, a foreign substance map of the four samples was prepared in the same manner as in Example 5. Two foreign substance maps were superimposed, and the degree of coincidence of each foreign substance map was evaluated, and as a result, the degree of coincidence was 99.0% or higher for any two maps. Note that the degree of coincidence (%) was calculated as (the number of coincident colors (black and white) of the foreign substance map) / (the total number of images of the foreign substance map (=1789 images)) × 100. For example, when two foreign substance maps each including 50 microscopic images are superimposed in which a foreign substance represented by black is detected, if all the black positions do not match, a matching rate is (1789-50×2) / 1789×100 = 94.4%.

By comparison between Examples 1 to 5 and Comparative Examples 1 to 3, it has been confirmed that Examples 1 to 5 of the present invention adopt a film forming method of forming a crystalline metal oxide film by subjecting a misted raw material solution to heat treatment on a base body, inhibit foreign substances and abnormal portions by irradiating the mist in the nozzle with microwaves to heat the mist, and can form a film having satisfactory crystallinity and satisfactory in-plane uniformity of the film thickness at a high speed. In addition, from Example 6, it was possible to form a film with little variation even on a plurality of base bodies.

The present description includes the following embodiments.
[1]: A film forming apparatus comprising:
   a misting unit that mists a raw material solution to generate mist;
   a carrier gas supply unit that supplies a carrier gas for transporting the mist;
   a film forming unit that subjects the mist to heat treatment and forms a film on a base body; and
   a transport unit that connects the misting unit with an inside of the film forming unit and transports the mist by the carrier gas, wherein
   the film forming unit comprises a nozzle for supplying the mist in a flow-straightened state to the base body, and a microwave heating device that irradiates the mist in the nozzle with microwaves in a multimode manner to heat the mist.
[2]: The film forming apparatus according to the above [1], wherein the microwave heating device comprises:
   a microwave generation unit;
   a microwave irradiation unit that irradiates the mist with microwaves generated in the microwave generation unit; and
   a microwave waveguide unit through which the microwaves propagate from the microwave generation unit to the microwave irradiation unit, wherein
   the microwave irradiation unit comprises a wall surface for irregularly reflecting the microwaves to irradiate the mist with the microwaves.
[3]: The film forming apparatus according to the above [1] or [2], wherein a portion of the nozzle to be irradiated with the microwaves is formed of a microwave-transmissive member.
[4]: The film forming apparatus according to any of the above [1] to [3], wherein a portion of the nozzle to be irradiated with the microwaves is formed of any one of quartz, ceramic, alumina, a polytetrafluoroethylene resin, a copolymer resin of tetrafluoroethylene and perfluoroalkyl vinyl ether, a copolymer resin of tetrafluoroethylene and hexafluoropropylene, and a polyether ether ketone resin.
[5]: The film forming apparatus according to any of the above [1] to [4], wherein a representative length of a discharge surface of the nozzle is larger than 3 cm, the mist being discharged from the discharge surface.
[6]: The film forming apparatus according to any of the above [1] to [5], wherein the film forming unit comprises a moving mechanism for moving the base body.
[7]: A film forming method comprising the steps of:
   generating mist by atomizing or dropletizing a raw material solution;
   transporting the mist to a film forming unit by a carrier gas; and
   forming a film on a base body by supplying the mist to the base body through a nozzle in the film forming unit, and subjecting the mist to heat treatment on the base body, wherein
   in the step of forming the film on the base body, the mist in the nozzle is irradiated with microwaves in a multimode manner to heat the mist.
[8]: The film forming method according to the above [7], wherein, as the raw material solution, a solution containing a metal raw material and at least one solvent selected from water, methanol, ethanol, ethylene glycol, diethylene glycol, propylene glycol, tetraethylene glycol, glycerol, benzyl alcohol, and dipropylene glycol is used.
[9]: The film forming method according to the above [7] or [8], wherein, as the solvent of the raw material solution, a solvent containing water as a main component is used.
[10]: The film forming method according to the above [8] or [9], wherein, as the metal raw material, a material containing Ga is used.
[11]: The film forming method according to any of the above [7] to [10], wherein, as the base body, a base body having a film-forming surface with a diameter of 10 cm (4 inches) or larger is used.
[12]: The film forming method according to any of the above [7] to [11], wherein, in the step of forming the film on the base body, the film is formed on the base body while the base body is being moved.
[13]: The film forming method according to any of the above [7] to [12], wherein a frequency of the microwaves is set to 0.9 GHz or higher and 300 GHz or lower.
[14]: The film forming method according to any of the above [7] to [13], wherein the frequency of the microwaves is set to 2.45 GHz or higher and 25 GHz or lower.
[15]: A crystalline metal oxide film comprising at least one of gallium or aluminum as a main component, wherein
   when a plurality of microscopic images of a plurality of portions of a surface of the crystalline metal oxide film are acquired, each of the microscopic images having an identical field-of-view area of 1 mm² or smaller, such that a total of the field-of-view areas is 20% or larger of an area of the surface of the crystalline metal oxide film and the fields of view of the microscopic images do not overlap, and
   when the number of foreign substances contained in each of the microscopic images is determined for all of the acquired microscopic images,
   a ratio of the number of microscopic images determined to contain a plurality of the foreign substances, to the total number of the acquired microscopic images is less than 10%.
[16]: The crystalline metal oxide film according to the above [15], wherein the number density of the foreign substances observed in a surface direction of the crystalline metal oxide film is less than 48/cm².
[17]: The crystalline metal oxide film according to the above [15] or [16], wherein a distribution of a film thickness measured at 17 or more positions of the crystalline metal oxide film is 4.6% or smaller.
[18]: The crystalline metal oxide film according to any of the above [15] to [17], wherein the crystalline metal oxide film has a corundum structure.
[19]: The crystalline metal oxide film according to any of the above [15] to [18], wherein a half width of a rocking curve of a (006) plane by X-ray diffraction of the crystalline metal oxide film is smaller than 19.1 s.
[20]: The crystalline metal oxide film according to any of the above [15] to [19], wherein a diameter of the surface of the crystalline metal oxide film is 10 cm (4 inches) or larger.
[21]: A layered structure comprising: a base body, a buffer layer on the base body, and the crystalline metal oxide film according to any of the above [15] to [20] on the buffer layer.
[22]: A semiconductor device comprising the crystalline metal oxide film according to any of the above [15] to [20], and/or the layered structure according to the above [21].
[23]: The semiconductor device according to the above [22], wherein the semiconductor device is any one of a semiconductor laser, a diode, or a transistor.

Note that the present invention is not limited to the above embodiments. The above embodiments are merely examples, and any embodiment having substantially the same configuration as the technical idea described in the claims of the present invention and exhibiting the same operation and effect is included in the technical scope of the present invention.

## Claims

1. A film forming apparatus comprising:
a misting unit that mists a raw material solution to generate mist;
a carrier gas supply unit that supplies a carrier gas for transporting the mist;
a film forming unit that subjects the mist to heat treatment and forms a film on a base body; and
a transport unit that connects the misting unit with an inside of the film forming unit and transports the mist by the carrier gas, wherein
the film forming unit comprises a nozzle for supplying the mist in a flow-straightened state to the base body, and a microwave heating device that irradiates the mist in the nozzle with microwaves in a multimode manner to heat the mist.

2. The film forming apparatus according to claim 1, wherein the microwave heating device comprises:
a microwave generation unit;
a microwave irradiation unit that irradiates the mist with microwaves generated in the microwave generation unit; and
a microwave waveguide unit through which the microwaves propagate from the microwave generation unit to the microwave irradiation unit, wherein
the microwave irradiation unit comprises a wall surface for irregularly reflecting the microwaves to irradiate the mist with the microwaves.

3. The film forming apparatus according to claim 1, wherein a portion of the nozzle to be irradiated with the microwaves is formed of a microwave-transmissive member.

4. The film forming apparatus according to claim 1, wherein a portion of the nozzle to be irradiated with the microwaves is formed of any one of quartz, ceramic, alumina, a polytetrafluoroethylene resin, a copolymer resin of tetrafluoroethylene and perfluoroalkyl vinyl ether, a copolymer resin of tetrafluoroethylene and hexafluoropropylene, and a polyether ether ketone resin.

5. The film forming apparatus according to claim 1, wherein a representative length of a discharge surface of the nozzle is larger than 3 cm, the mist being discharged from the discharge surface.

6. The film forming apparatus according to any one of claim 1 to claim 5, wherein the film forming unit comprises a moving mechanism for moving the base body.

7. A film forming method comprising the steps of:
generating mist by atomizing or dropletizing a raw material solution;
transporting the mist to a film forming unit by a carrier gas; and
forming a film on a base body by supplying the mist to the base body through a nozzle in the film forming unit, and subjecting the mist to heat treatment on the base body, wherein
in the step of forming the film on the base body, the mist in the nozzle is irradiated with microwaves in a multimode manner to heat the mist.

8. The film forming method according to claim 7, wherein, as the raw material solution, a solution containing a metal raw material and at least one solvent selected from water, methanol, ethanol, ethylene glycol, diethylene glycol, propylene glycol, tetraethylene glycol, glycerol, benzyl alcohol, and dipropylene glycol is used.

9. The film forming method according to claim 8, wherein, as the solvent of the raw material solution, a solvent containing water as a main component is used.

10. The film forming method according to claim 8, wherein, as the metal raw material, a material containing Ga is used.

11. The film forming method according to claim 7, wherein, as the base body, a base body having a film-forming surface with a diameter of 10 cm (4 inches) or larger is used.

12. The film forming method according to claim 7, wherein, in the step of forming the film on the base body, the film is formed on the base body while the base body is being moved.

13. The film forming method according to any one of claim 7 to claim 12, wherein a frequency of the microwaves is set to 0.9 GHz or higher and 300 GHz or lower.

14. The film forming method according to claim 13, wherein the frequency of the microwaves is set to 2.45 GHz or higher and 25 GHz or lower.

15. A crystalline metal oxide film comprising at least one of gallium or aluminum as a main component, wherein
when a plurality of microscopic images of a plurality of portions of a surface of the crystalline metal oxide film are acquired, each of the microscopic images having an identical field-of-view area of 1 mm² or smaller, such that a total of the field-of-view areas is 20% or larger of an area of the surface of the crystalline metal oxide film and the fields of view of the microscopic images do not overlap, and
when the number of foreign substances contained in each of the microscopic images is determined for all of the acquired microscopic images,
a ratio of the number of microscopic images determined to contain a plurality of the foreign substances, to the total number of the acquired microscopic images is less than 10%.

16. The crystalline metal oxide film according to claim 15, wherein the number density of the foreign substances observed in a surface direction of the crystalline metal oxide film is less than 48/cm².

17. The crystalline metal oxide film according to claim 15, wherein a distribution of a film thickness measured at 17 or more positions of the crystalline metal oxide film is 4.6% or smaller.

18. The crystalline metal oxide film according to claim 15, wherein the crystalline metal oxide film has a corundum structure.

19. The crystalline metal oxide film according to claim 15, wherein a half width of a rocking curve of a (006) plane by X-ray diffraction of the crystalline metal oxide film is smaller than 19.1 s.

20. The crystalline metal oxide film according to claim 15, wherein a diameter of the surface of the crystalline metal oxide film is 10 cm (4 inches) or larger.

21. A layered structure comprising: a base body, a buffer layer on the base body, and the crystalline metal oxide film according to claim 15 on the buffer layer.

22. A semiconductor device comprising the crystalline metal oxide film according to any one of claims 15 to 20, and/or the layered structure according to claim 21.

23. The semiconductor device according to claim 22, wherein the semiconductor device is any one of a semiconductor laser, a diode, or a transistor.
